**Europäisches Patentamt**

**European Patent Office**

**Office européen des brevets**

(19)

(11) Veröffentlichungsnummer : **0 025 845**
**B1**

(12) **EUROPÄISCHE PATENTSCHRIFT**

(45) Veröffentlichungstag der Patentschrift :
**22.01.86**

(21) Anmeldenummer : **80104633.5**

(22) Anmeldetag : **06.08.80**

(51) Int. Cl.⁴ : **H 03 M   1/00**, H 03 M   1/02

(54) Monolithisch integrierte Halbleiterschaltung und Verfahren zum Betreiben dieser Halbleiterschaltung.

(30) Priorität : **30.08.79 DE 2935107**

(43) Veröffentlichungstag der Anmeldung :
**01.04.81 Patentblatt 81/13**

(45) Bekanntmachung des Hinweises auf die Patenterteilung : **22.01.86 Patentblatt 86/04**

(84) Benannte Vertragsstaaten :
**FR GB**

(56) Entgegenhaltungen :
**DE-A- 2 704 711**
**DE-A- 2 704 718**
**DE-A- 2 708 636**
**DE-A- 2 813 225**
**DE-A- 2 816 259**
**US-A- 4 171 521**
**US-A- 4 206 446**

(73) Patentinhaber : **Siemens Aktiengesellschaft**
**Berlin und München Wittelsbacherplatz 2**
**D-8000 München 2 (DE)**

(72) Erfinder : **Bardl, Artur, Ing. grad.**
**Grabmannstrasse 21**
**D-8000 München 71 (DE)**

**Beschreibung**

Gegenstand der vorliegenden Erfindung ist eine monolithisch integrierte, im Zeittakt betriebene Ladungstransportanordnung (CCD-Anordnung) zur Umwandlung einer ersten Signalart in eine zweite Signalart, wobei die eine Signalart analog, die andere digital auftritt.

Solche Halbleiterschaltungen sind entweder Analog-Digitalwandler oder Digital-Analogwandler und können auf der Grundlage verschiedener Arbeitsprinzipien aufgebaut sein. Eine als Analog-Digitalwandler bzw. Digital-Analogwandler arbeitende CCD-Anordnung ist in der DE-A1-27 08 636 beschrieben. Es ist Aufgabe der Erfindung, eine neue Möglichkeit anzugeben.

Hierzu wird gemäß der Erfindung eine der oben gegebenen Definition entsprechende monolithisch integrierte Ladungstransportanordnung so ausgestaltet, daß die Ladungstransportanordnung als Analog-Addierer ausgebildet ist, der durch einen MOS-Kondensator gegeben ist, der einerseits über eine Schwelle mit einem durch eine Ladungsquelle beaufschlagten weiteren MOS-Kondensator in Verbindung steht und andererseits durch wenigstens einen durch das am Signaleingang der Anordnung anhängige Signal beaufschlagten MOS-Kondensator über eine Schwelle unter Vermittlung wenigstens eines weiteren MOS-Kondensators beaufschlagt ist.

Eine derartige Ladungstransportanordnung läßt sich, wie im folgenden gezeigt wird, sowohl in Form eines Analog-Digitalwandlers als auch in Gestalt eines Digital-Analogwandlers ausgestalten, wobei ein wesentlicher Bestandteil durch die als Analog-Addierer ausgebildete CCD-Anordnung gegeben ist.

Einzelheiten über Ladungstransportschaltungen, insbesondere über CCD-Anordnungen, sind z. B. in « Der Elektroniker » Nr. 2/1978, S. EL 1-EL6 und Nr. 3/1978, S. EL7-EL14 beschrieben. Solche Ladungstransportschaltungen werden z. B. als taktgesteuerte Schieberegister oder als elektronische Filter eingesetzt und dementsprechend ausgestaltet. Bevorzugt bestehen sie aus einem n-dotierten Bereich eines Siliciumeinkristalls, dessen Oberfläche mit einer dünnen $SiO_2$-Schicht bedeckt ist, die als Träger einer Anzahl von Gateelektroden dient. Jede dieser Gateelektroden bildet mit dem genannten n-dotierten Bereich des Siliciumeinkristalls einen MOS-Kondensator, dessen einer Anschluß durch die zugehörige Gateelektrode und dessen zweiter Anschluß durch eine den genannten Bereich des Siliciumeinkristalls sperrfrei kontaktierende Elektrode gegeben ist.

Wesentlich für den Betrieb einer CCD-Anordnung ist, daß die die einzelnen MOS-Kondensatoren definierenden Gateelektroden so dicht hintereinander auf der $SiO_2$-Schicht angebracht sind, daß die Verarmungszone des einen Kondensators in die Bereiche des Siliciumkristalls unter den jeweils benachbarten Gateelektroden und damit des von diesen gebildeten MOS-Kondensators übergreifen kann. Dann kann die Ladung beim Abschalten der Spannung am einen Kondensator in den benachbarten, im selben Augenblick an Spannung gelegten Kondensator abfließen. Dies bedeutet, daß die in einer Reihe auf dem Siliciumkristall angeordneten Gateelektroden der MOS-Kondensatoren durch Taktimpulse derart gesteuert werden, daß der Ladungstransport sukzessive durch die Kette von MOS-Kondensatoren vom Signaleingang bis zum Signalausgang erfolgt.

Die Ladungsquelle entspricht der Source und der Ausgangsteil dem Drain eines MOS-Feldeffektransistors vom Anreicherungstyp. Die zwischen der Ladungsquelle und dem Ausgangsteil liegenden Gateelektroden der MOS-Kondensatoren der CCD-Anordnung steuern abschnittsweise den zwischen der Ladungsquelle und dem Ausgangsteil liegenden Kanal.

Die der Ladungsquelle benachbarten ersten Gateelektroden und die durch diese definierten MOS-Kondensatoren erzeugen Ladungspakete nach Maßgabe eines zwischen der Ladungsquelle und dem Halbleiterbereich der MOS-Kondensatoren anliegenden Analogsignals und nach Maßgabe einer Abtastfrequenz, derart, daß die Größe der jeweils anfallenden Ladungspakete dem jeweiligen Wert der Amplitude des Analogsignals entspricht. Diese Ladungspakete werden an die der eigentlichen CCD-Kette angehörenden taktgesteuerten MOS-Kondensatoren weitergegeben. Jeder dieser MOS-Kondensatoren der CCD-Kette führt eine elektrische Ladung, die einem durch die Abtastung erhaltenen Amplitudenwert des Analogsignals entspricht. Da man die Abtastfrequenz entsprechend dem Nyquisttheorem genügend groß wählt, um aufgrund der durch die Abtastung in ihrer zeitlichen Reihenfolge erhaltenen Ladungspakete das Analogsignal in seiner ursprünglichen Gestalt mit der erforderlichen Genauigkeit wieder herstellen zu können, wandert im Laufe des Betriebs einer solchen CCD-Anordnung die gesamte aufgrund eines anstehenden Analogsignals erhaltene Information über jede Elektrode der CCD-Anordnung, die somit zum Ausgangspunkt einer Vorrichtung gemäß der Erfindung gemacht werden kann.

Demzufolge ist bei einer ersten bevorzugten Ausgestaltung der erfindungsgemäßen Ladungstransportschaltung diese als Analog-Digitalwandler ausgebildet, wobei ein analog zu beaufschlagender Signaleingang mit anschließender Signalverarbeitung, also einem Abtaster mit nachfolgender Filterfunktion (Tiefpaß) als Eingangsteil vorgesehen ist. Dieser Eingangsteil ist in der bei CCD-Anordnungen üblichen Weise ausgestaltet. Ferner ist ein Abtast-Halteglied, also ein Sample-Hold-Glied, als erster MOS-Kondensator vorgesehen, der im folgenden als « Meßtopf » bezeichnet wird. Dieser Meßtopf dient zur Aufnahme der einzelnen vom Signalabtaster gelieferten Ladungspakete.

Ein im folgenden als « Invertertopf » bezeichneter zweiter MOS-Kondensator der gleichen Größe wie der Meßtopf ist über eine gate-gesteuerte erste Schwelle mit einem — im folgenden als « Verdopplertopf » bezeichneten — dritten MOS-Kondensator der gleichen Größe gekoppelt, der seinerseits über eine gate-gesteuerte zweite Schwelle an eine als Diffusionsgebiet, also als Source, ausgestaltete erste Ladungsquelle anschaltbar ist. Schließlich ist sowohl der erste MOS-Kondensator als auch der zweite MOS-Kondensator über je eine taktgesteuerte Schwelle an je einen um den Faktor 1/16 kleineren MOS-Kondensator geschaltet. Diese beiden kleineren MOS-Kondensatoren werden im folgenden als « Identifizierungstöpfe » bezeichnet. Jeder dieser beiden Identifizierungstöpfe ist durch je eine gate-gesteuerte Schwelle an einen gemeinsamen weiteren MOS-Kondensator, dem den Kern der Schaltung bildenden « Summationstopf » anschaltbar, dessen Größe der Größe des Meßtopfs entspricht. Dieser Summationstopf ist andererseits über eine weitere gate-gesteuerte Schwelle durch einen ebenso großen weiteren MOS-Kondensator, dem zweiten « Verdopplertopf » beaufschlagt, der ebenso wie der erste Verdopplertopf über eine gate-gesteuerte Schwelle mit einer zweiten Ladungsquelle verbunden ist. Eine solche Anlage funktioniert als Analog-Digitalwandler.

Bei einer der Umwandlung eines Digitalsignals in ein Analogsignal dienenden Ausgestaltung einer Halbleiterschaltung gemäß der Erfindung ist der durch ein vorzugsweise auf binärer Grundlage beruhendes Digitalsignal zu beaufschlagende Signaleingang zur Einstellung des Ausgangszählstandes eines Rückwärtszählers vorgesehen, der durch einen Impulse liefernden Teil der Halbleiterschaltung an seinem Zähleingang gesteuert ist. Dieser Impulse liefernde Schaltungsteil steuert außerdem die Entstehung von aus einer Ladungsquelle stammenden, gleichgroßen Ladungspaketen, die über eine Ladungstransportanlage dem als Analog-Addierer ausgebildeten und dem Summationstopf bei der ersten Ausgestaltung der Erfindung entsprechenden Teil der Anlage zugeführt werden. Die Gesamtzahl der jeweils an den als Analog-Addierer ausgebildeten Teil der Anlage gegebenen Ladungspakete wird durch die Größe des jeweils anhängigen Signals festgelegt. Der Ausgang des Analog-Addierers, der insbesondere ebenfalls durch einen durch ein Abtast-Halteglied gesteuerten MOS-Kondensator gegeben ist, steuert den Signalausgang der als Digital-Analogwandler wirkenden Halbleiterschaltung.

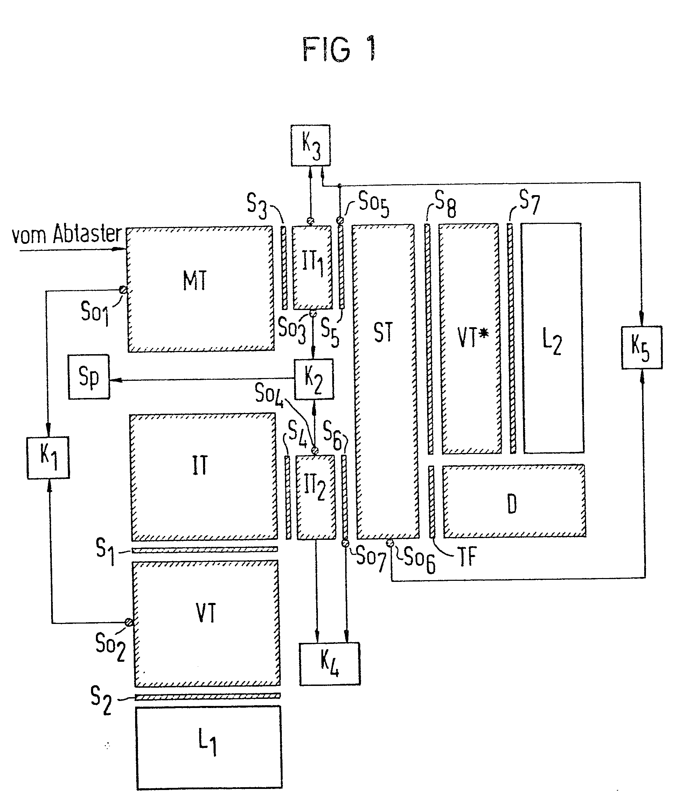

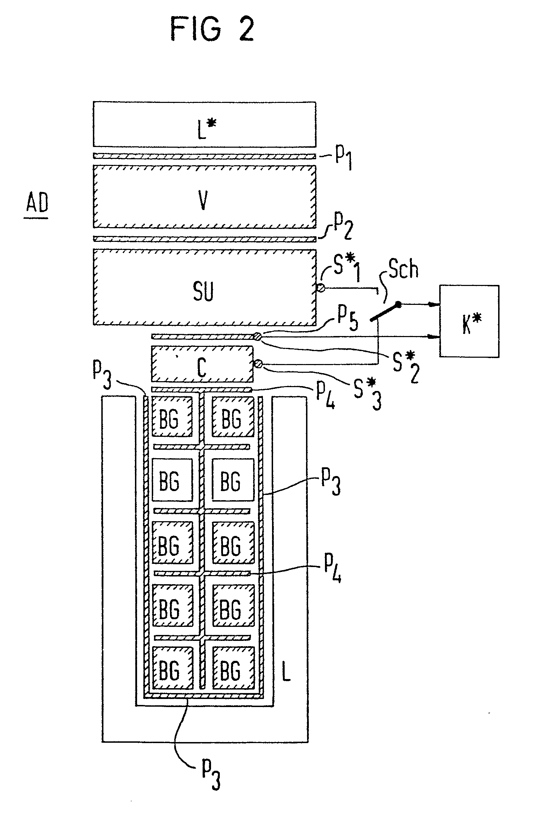

In Fig. 1 ist der Kern einer als Analog-Digitalwandler dienenden Halbleiterschaltung und in Fig. 2 der Kern einer als Digital-Analogwandler dienenden Halbleiterschaltung gemäß der Erfindung dargestellt. Da die Größe und Gestalt der die einzelnen Bestandteile der Halbleiterschaltung bildenden MOS-Kondensatoren durch ihre Gateelektrode festgelegt ist, genügt es, sie durch die Umrisse ihrer Gateelektroden darzustellen. Dasselbe gilt für die zwischen den MOS-Kondensatoren vorgesehenen Schwellen bzw. Transfergates und die Ladungsquellen.

Bei der in Fig. 1 dargestellten Halbleiterschaltung gemäß der Erfindung gelangen die aufgrund eines am Signaleingang anhängigen Analogsignals mittels eines bei CCD-Anlagen üblichen und mit einer Abtastfrequenz $f_A$ arbeitenden Abtasters erzeugten und die Amplitudenwerte des anhängigen Signals repräsentierenden Ladungspakete in der Reihenfolge ihrer Entstehung in den ersten MOS-Kondensator, also den Meßtopf MT, der zu diesem Zweck an eine entsprechende Spannung gelegt ist. Somit bildet der Meßtopf MT einen Bestandteil einer üblichen Ladungstransportanlage, also CCD-Anlage. Das den Meßtopf MT bildende Gate liegt an einem auf die Taktsignale des Abtasters und deren Frequenz $f_A$ abgestimmten Potential, das nach jeweiliger Aufnahme eines Ladungspakets solange aufrecht erhalten bleibt, bis sich die zusammen mit dem jeweiligen Ladungsinhalt des Meßtopfs MT an den Summationstopf ST weiterzugebende Vergleichsladung im Invertertopf IT aufgebaut hat. Damit stellt der Meßtopf die Sample-Hold-Schaltung des Analog-Digitalwandlers gemäß Fig. 1 dar.

Um die erforderlichen Vergleichsmöglichkeiten zwischen den einzelnen Ladungspaketen und Vergleichsladungen zu ermöglichen, sind Meßsonden für die Oberflächenpotentiale der MOS-Kondensatoren und einiger Schwellen sowie den jeweiligen Vergleich ermöglichende Komparatoren vorgesehen. Zu bemerken ist ferner, daß auch hier der sog. Grundladungsbetrieb angewendet wird, so daß also bei jedem der Ladungstransportvorgänge im alten MOS-Kondensator Ladung zurückbleibt, die dann durch die Grundladung in neuen MOS-Kondensator dem um den Betrag der Grundladung verminderten Signalladungspaket wieder ersetzt wird.

Mit Rücksicht auf die erwähnten Meßsonden und Komparatoren ist im Hinblick auf eine Anlage gemäß der Erfindung festzustellen, daß die Meßsonden, z. B. die Meßsonde im Bereich des Meßtopfs MT, durch je einen sperrfreien Kontakt der Halbleiteroberfläche gegeben ist. Die dem Meßtopf zugeteilte Sonde ist die Sonde $So_1$. Die Meßsonden haben die Aufgabe, das sich an ihrem Ort, z. B. im Falle der Sonde $So_1$ am Meßtopf MT, sich aufgrund der jeweils gespeicherten Ladung an der Halbleiteroberfläche einstellende Oberflächenpotential $\varphi_s$ gemäß der Beziehung

$$\varphi_s = U_g + Q_s/C_o - U_{FB}$$

($U_g$ = Spannung zwischen dem betreffenden Gate und dem sperrfreien Anschluß des die MOS-Kondensatoren bildenden Halbleiterbereichs ;

$Q_s$ = Gesamtladung pro Flächeneinheit, welche innerhalb der betreffenden Raumladungszone enthalten ist ;

$C_o$ = Oxyd-Kapazität pro Flächeneinheit ;

$U_{FB}$ = Flachbandspannung)

festzustellen. Sie steuert nach Maßgabe des jeweils ermittelten Wertes des Oberflächenpotentials $\varphi_s$ einen Komparator $K_1$. Festzustellen ist ferner, daß an der Oberfläche des Halbleiterbereichs am Verdopplertopf VT eine zweite Sonde $So_2$ zur Feststellung des sich aufgrund der in den Verdopplertopf

3

**0 025 845**

jeweils einfließenden Ladung einstellenden Wertes des Oberflächenpotentials $\varphi_s$ vorgesehen ist, welche auf den Referenzeingang des Komparators $K_1$ arbeitet.

Der zweite MOS-Kondensator bei der in Fig. 1 dargestellten Halbleiterschaltung gemäß der Erfindung ist der Invertertopf IT, der durch seine Gateelektrode in der Nachbarschaft des Meßtopfs MT definiert ist. Die den Invertertopf IT definierende Gateelektrode ist mit der Gateelektrode des Meßtopfs flächengleich und unter denselben Bedingungen wie diese hergestellt. Dasselbe gilt für die den dritten MOS-Kondensator, also den ersten Verdopplertopf VT definierende Gateelektrode.

Während die Ausgestaltung dieser Gateelektroden so getroffen ist, daß kein Ladungsübergang zwischen dem Meßtopf MT und dem Invertertopf IT möglich ist, ist ein solcher Ladungsübergang zwischen dem ersten Verdopplertopf VT und dem Invertertopf IT über eine Schwelle $S_1$ vorgesehen. Die diese Schwelle und auch die weiteren Schwellen definierenden Gateelektroden sind im Gegensatz zu den die MOS-Kondensatoren definierenden Gateelektroden in bekannter Weise so ausgebildet, daß sie zwar den Ladungsfluß zwischen den durch sie kontrollierten MOS-Kondensatoren, also im Beispielsfall zwischen dem ersten Verdopplertopf VT und dem Invertertopf IT, kontrollieren, insbesondere auch sperren kann, daß sie aber andererseits aufgrund ihrer geringen Fläche praktisch keine Ladung speichert und somit nicht als MOS-Kondensator wirkt.

Eine weitere Schwelle $S_2$ befindet sich zwischen dem Verdopplertopf VT und einer ersten Ladungsquelle $L_1$. Diese ist durch eine Diffusionszone vom entgegengesetzten Leitungstyp zu dem die MOS-Kondensatoren bildenden Halbleiterbereich, also im Beispielsfall vom $p^-$-Typ gegeben, die in gleicher Weise wie die Sourcezone eines MOS-Feldeffekttransistors mit einem sperrfreien Anschluß versehen ist.

Zur Ladungsübernahme aus der ersten Ladungsquelle $L_1$ liegt gleichzeitig oder unmittelbar nach der Aufnahme eines Ladungspakets in den Meßtopf MT das Gate des ersten Verdopplertopf VT am Potential des Gates des Meßtopfs MT. Dabei wird der Anschluß der Ladungsquelle $L_1$ dem Spannungswert von OV genähert, so daß sich bei geöffneter Schwelle $S_2$ eine Ladungsmenge in den Verdopplertopf VT ergießt, die viel größer als die Signalladung im Meßtopf MT ist.

Nach dem Einfüllen dieser Ladung in den ersten Verdopplertopf VT wird bei geöffneter Schwelle $S_2$ das Potential am Anschluß der ersten Ladungsquelle $L_1$ auf den Wert des am Gate des ersten Verdopplertopfs VT liegenden Potentials zurückgebracht, so daß überschüssige Ladung in die Ladungs-quelle $L_1$ zurückfließt. Es verbleibt dann genau eine Ladungsmenge im ersten Verdopplertopf VT, die der Summe aus der doppelten Grundladung und des bei maximaler Signalamplitude vorliegenden Ladungspakets im Meßtopf MT entsricht. Nach dem Ladungsausgleich zwischen dem ersten Verdopplertopf VT und der ersten Ladungsquelle $L_1$ wird die Schwelle $S_2$ geschlossen und die Möglichkeit geschaffen, eine der Grundladung entsprechende Ladungsmenge aus dem Verdopplertopf VT in den Invertertopf IT zu übertragen.

Hierzu gibt es verschiedene Möglichkeiten. Am einfachsten ist es, wenn man nunmehr das bisher unbeteiligte Gate des Invertertopfs IT auf das Potential des Gates am Meßtopf MT und am ersten Verdopplertopf VT bringt und damit die Möglichkeit einer Ladungseingabe aus dem Verdopplertopf VT in den Invertertopf IT über die Schwelle $S_1$ (die spätestens zu diesem Zeitpunkt geöffnet sein muß) schafft. Die Potentialdifferenz zwischen dem Gate der Schwelle $S_1$ und dem Gate der Schwelle $S_2$ wird so eingestellt, daß genau die Grundladung aus dem Verdopplertopf VT in den Invertertopf IT überfließt.

Anderseits kann man auch im vornherein die Gates der MOS-Kondensatoren MT, IT und VT zusammenschalten und das Potential des die Schwelle $S_1$ definierenden Gates veränderlich derart gestalten, daß die Schwelle $S_1$ erst im Zeitpunkt der Ladungsübertragung in den Invertertopf IT geöffnet ist. Schließlich kann man auch zusätzlich zur Schwelle $S_1$ ein Transfergate zwischen dem Verdopplertopf VT und dem Invertertopf IT vorsehen, so daß das Potential des die aus dem Verdopplertopf VT an den Invertertopf IT zu übertragende Grundladungsmenge festlegenden Gates der Schwelle $S_1$ (das auch noch zur Steuerung der Ladungsabgabe aus dem Invertertopf IT in Richtung auf den Summationstopf ST herangezogen werden kann) festgehalten werden kann.

Ist nun bei festgehaltenem Potential an den Gates des Meßtopfs MT, des Invertertopfs IT und des ersten Verdopplertopfs VT die Grundladungsmenge auf den Invertertopf IT übertragen, so wird in dem folgenden Verfahrensschritt unter Aufrechterhaltung des Wertes des Potentials am Gate des Invertertopfs IT das Potential an den Gates des Meßtopfs MT und des Verdopplertopfs VT gemeinsam in Richtung auf das Potential des Anschlusses des die MOS-Kondensatoren bildenden Halbleiterbereiches verschoben, d. h. abgesenkt, wodurch die Raumladungszone in den beiden MOS-Kondensatoren IT und VT, also im Meßtopf und im Verdopplertopf, reduziert und das Oberflächenpotential $\varphi_s$ der beiden MOS-Kondensato-ren einander angeglichen wird.

Ist der Zustand der Gleichheit der Oberflächenpotentiale am Meßtopf MT und am ersten Verdopplertopf VT erreicht, so bedeutet dies, daß die bewegliche Ladung im ersten Verdopplertopf VT infolge der bereits erfolgten Ladungsabgabe an den Invertertopf IT auf den Wert der beweglichen Ladung im Meßtopf MT und damit auf den Istwert des Signals abgesunken ist. Dies bedeutet, daß infolge der gemeinsamen Potentialabsenkung an den Gates des Meßtopfs MT und des Verdopplertopfs VT soviel bewegliche Ladung aus dem Verdopplertopf VT an den Invertertopf IT abgegeben worden ist, daß der Invertertopf zusätzlich zur Grundladung noch eine Ladungsmenge enthält, die gleich der Differenz der der maximalen Signalamplitude zugeordneten Ladungsmenge und der den Signal-Istwert darstellenden

4

beweglichen Ladung im Meßtopf MT ist und aus diesem Grunde dem invertierten bzw. komplementären Signal zugeordnet werden kann.

Das Erreichen dieses Zustandes wird über die beiden Potential-Meßsonden $So_1$ und $So_2$ im Komparator $K_1$ festgestellt. Unmittelbar mit dem Erreichen dieses Zustandes wird durch die Wirkung des Komparators $K_1$, z. B. durch Anheben der Schwelle $S_1$ bzw. durch Abschalten des Potentials am Gate der Schwelle $S_1$ der Ladungsübergang aus dem Verdopplertopf VT in den Invertertopf IT abrupt beendet, so daß für das weitere der Invertertopf IT die Grundladung und die dem invertierten Signal entsprechende Ladung führt.

Nunmehr erfolgt die Abschaltung des Gates des ersten Verdopplertopfes VT vom Potential des Gates des Meßtopfs MT. Letzteres wird dann auf den ursprünglichen Wert wieder angehoben. Dann erfolgt der Anschluß des (dasselbe Potential aufweisenden) Gates des Invertertopfs IT an das Gate des Meßtopfs MT.

Im nächsten Schritt erfolgt ein Vergleich zwischen dem Ladungsinhalt des Meßtopfs MT und dem Ladungsinhalt des Invertertopfs IT. Hierzu ist der Meßtopf MT über eine gate-gesteuerte Schwelle $S_3$ an den ersten Identifizierungstopf $IT_1$, und der Invertertopf IT über eine weitere gate-gesteuerte Schwelle $S_4$ an den zweiten Identifizierungstopf $IT_2$ gelegt. Beide Identifizierungstöpfe $IT_1$ und $IT_2$ haben dieselbe Fläche und dieselbe Entstehungsgeschichte. Ihre Fläche beträgt den sechzehnten Teil der Fläche der die übrigen MOS-Kondensatoren der Anlage definierenden Gateelektroden.

Jeder der beiden Identifizierungstöpfe $IT_1$ und $IT_2$ ist über eine zur Feststellung des jeweiligen Oberflächenpotentials $\varphi_s$ dienende Sonde $So_3$ bzw. $So_4$ mit einem zweiten Komparator $K_2$ gekoppelt. Dieser hat die Aufgabe, festzustellen, ob die Ladung im Meßtopf MT oder die Ladung im Invertertopf IT größer ist. Dem ersten dieser beiden Zustände wird das Vorzeichen « + », dem zweiten Zustand das Vorzeichen « − » zugeordnet.

Am einfachsten ist es hierbei, wenn man das die Schwelle $S_4$ bestimmende Gate mit dem Gate der Schwelle $S_3$ verbindet. Die Schwellen $S_3$ und $S_4$ werden dann durch dasselbe Potential gesteuert. Um den Vergleich durchzuführen, wird nun das Potential des den Meßtopf MT definierenden Gate und das mit diesem Gate verbundene, den Invertertopf IT definierende Gate in Richtung auf das Potential des Anschlusses des die MOS-Kondensatoren der Anordnung enthaltenden Halbleiterbereiches verschoben. Wegen gleicher Einstellung der beiden Schwellen $S_3$ und $S_4$ fließt aus demjenigen der beiden MOS-Kondensatoren MT und IT zuerst Ladung in den zugehörigen Identifizierungstopf $IT_1$ bzw. $IT_2$ ab, der die größere Ladungsmenge enthält. Die abfließende Ladung gelangt somit entweder in den ersten Identifizierungstopf $IT_1$ oder in den zweiten Identifizierungstopf $IT_2$. Dadurch wird das Oberflächenpotential $\varphi_s$ des betreffenden Identifizierungstopfs abgeändert und damit der vorher vorhandene Zustand der Gleichheit der Betriebszustände der beiden Sonden $So_3$ und $So_4$ gestört, so daß der Komparator $K_2$ anspricht. Im Augenblick des Ansprechens des Komparators $K_2$ wird der Vorgang der Potentialverschiebung an den den Meßtopf MT und den Invertertopf IT definierenden Gateelektroden abrupt beendet.

Das Ansprechen des zweiten Komparators $K_2$ besagt, daß der Inhalt an beweglicher Ladung im Meßtopf MT entweder größer oder kleiner als die halbe für den Eingang der Schaltung verfügbare Signalbreite ist. Dem ersten Fall wird der Zustand « 1 », dem zweiten Fall der Zustand « 0 » zugeordnet. Der jeweils eintretende Fall, d. h. der ihm entsprechende Betriebszustand des zweiten Komparators $K_2$, steuert das Verhalten einer Speicherzelle Sp, die dem höchstwertigsten Bit des vorliegenden Analog-Digitalwandlers zugeordnet ist, derart, daß im ersten Fall eine logische « 1 », im zweiten Fall eine logische « 0 » als höchste Dualstelle des Ergebnisses gespeichert wird.

Unmittelbar danach wird das Potential an den Gates des Meßtopfs MT und des Invertertopfs IT in der bisherigen Weise in Richtung auf das Potential des Anschlusses des Halbleiterbereiches der MOS-Kondensatoren weiter verschoben, wodurch derjenige der beiden MOS-Kondensatoren MT und IT, der das Ansprechen des Komparators $K_2$ veranlaßt hat, weiter Ladung an den ihm zugeordneten Identifizierungstopf abgibt, bis auch der andere der beiden Identifizierungstöpe $IT_1$ und $IT_2$ anfängt, Ladung aus dem ihm zugeordneten MOS-Kondensator zu erhalten. Unmittelbar mit dem Beginn der Ladungsaufnahme durch den anderen Identifizierungstopf wird ein sogenannter Ladungserkennungsprozeß über die dem anderen Identifizierungstopf zugeordneten Meßsonde zur Bestimmung des Oberflächenpotentials $\varphi_s$ ausgelöst.

Hat man den oben beschriebenen Fall, daß in dem Speicher Sp eine « 1 » eingespeichert wird, so zeigt die Sonde $So_4$ an, daß der ihr zugeordnete Identifizierungstopf $IT_2$ als letzter der beiden Identifizierungstöpfe $IT_1$ und $IT_2$ Ladung aufzunehmen beginnt. Ist hingegen in dem Speicher Sp eine « 0 » gespeichert worden, so löst die dem ersten Identifizierungstopf $IT_1$ zugeordnete Sonde $So_3$ den Vorgang der Ladungserkennung aus.

Diese Ladungserkennung kann durch Umschalten des Eingangs des Komparators $K_2$ von der den Ladungserkennungsvorgang auslösenden der beiden Sonden $So_3$ bzw. $So_4$ auf eine (in der Figur nicht dargestellte) Referenzspannungsquelle $Q_{ref}$ geschehen, während die andere Sonde mit dem ihr zugeordneten Eingang des Komparators $K_2$ nachwievor verbunden bleibt. Die Referenzspannungsquelle $Q_{ref}$ ist so ausgestaltet, daß ihre Spannung der Oberflächenspannung $\varphi_s$ eines leeren Identifizierungstopfes $IT_1$ bzw. $IT_2$ entspricht. Sie läßt sich deshalb leicht durch einen zusätzlichen MOS-Kondensator mit der Größe der Identifizierungstöpfe realisieren, dessen Gate am selben Potential wie die Gates der Identifizierungstöpfe $IT_1$ und $IT_2$ liegt. Bei auftretender Ladung in dem anderen der beiden Identifizierungstöpfe $IT_1$, $IT_2$ spricht, wie festgestellt, der Komparator $K_2$ wegen der beginnenden Änderung des

Oberflächenpotentials $\varphi_s$ an dem betreffenden Identifizierungstopf an, wodurch das Absenken der Spannung an den Gates des Meßtopfs MT und des Identifizierungstopfs IT gestoppt wird.

Außer dem Meßtopf MT, dem Invertertopf IT, dem ersten Verdopplertopf VT und den beiden Identifizierungstöpfen und einem ggf. zur Darstellung der Referenzspannungsquelle dienenden MOS-Kondensator sind als weitere MOS Kondensatoren die den Analog-Addierer bildenden MOS-Kondensatoren ST und VT* sowie eine zweite Ladungsquelle $L_2$ vorgesehen. Außerdem enthält die Anordnung zwei weitere den beiden Identifizierungstöpfen $IT_1$ und $IT_2$ zugeordnete Komparatoren nebst zugehöriger Meßsonden für das Oberflächenpotential $\varphi_s$, einen weiteren durch die Oberflächenpotentiale an der Schwelle $S_4$ und am Summationstopf ST gesteuerten Komparator und schließlich eine durch den Summationstopf über ein Transfergate TF zu beaufschlagende Dekodierungsanlage D.

Der erste der genannten weiteren MOS-Kondensatoren ist der Summationstopf ST. Er bildet den Kern des Analog-Addierers und ist durch eine gategesteuerte Schwelle $S_5$ vom ersten Identifizierungstopf $IT_1$ und durch eine weitere gategesteuerte Schwelle $S_6$ vom zweiten Identifizierungstopf $IT_2$ getrennt. Das Oberflächenpotential $\varphi_s$ an der Schwelle $S_5$ dient zur Steuerung des bereits angedeuteten Komparators $K_5$.

Ebenso wie der Summationstopf ST ist der zweite der noch genannten MOS-Kondensatoren, nämlich der zweite Verdopplertopf VT* mit dem Summationstopf ST und damit mit dem Meßtopf MT flächengleich. Dem zweiten Verdopplertopf VT* ist die zweite Ladungsquelle $L_2$ zugeordnet, die im Aufbau und in der Funktion der Ladungsquelle $L_1$ beim ersten Verdopplertopf VT entspricht. Der Ladungsübertritt zwischen der zweiten Ladungsquelle $L_2$ und dem zweiten Verdopplertopf VT* wird durch eine Schwelle $S_7$ unter entsprechender Einstellung des Potentials an deren Gateelektrode gesteuert. Schließlich befindet sich zwischen dem zweiten Verdopplertopf VT* und dem Summationstopf ST noch eine gategesteuerte Schwelle $S_8$ und zwischen dem Summationstopf und dem Eingang der Dekodierungsanlage D das bereits erwähnte Transfergate TF.

Wird nun die Gateelektrode des zweiten Identifizierungstopfs $IT_2$ mit der Gateelektrode des ersten Identifizierungstopfes $IT_1$ verbunden und das Potential dieser beiden Gateelektroden dem Potential des Anschlusses des die MOS-Kondensatoren bildenden Halbleiterbereichs genähert, so fließt Ladung aus dem Identifizierungstopf $IT_2$ über die Schwelle $S_6$ in den Summationstopf ST, falls vorher in den Speicher Sp eine « 1 » eingegeben wurde. Ist hingegen in den Speicher eine « 0 » eingegeben worden, so fließt aufgrund der genannten Potentialverschiebung Ladung aus dem Identifizierungstopf $IT_1$ über die Schwelle $S_5$ in den Summationstopf ST.

Jedesmal beim Ansprechen des zweiten Komparators $K_2$ ist aufgrund der vorstehenden Ausführungen angezeigt, daß nunmehr im Meßtopf MT und im Invertertopf IT dieselbe Ladungsmenge vorliegt, so daß aus deren Ladungsinhalt von nun an keine weiteren Informationen abgeleitet werden können. Die in diesen beiden MOS-Kondensatoren MT und IT noch vorhandene Ladung kann deshalb in bekannter Weise, z. B. durch Absaugen, aus den beiden MOS-Kondensatoren MT und IT sowie aus dem ersten Verdopplertopf VT entfernt und damit diese MOS-Kondensatoren für die Aufbereitung des nächsten vom Abtaster an den Meßtopf MT gelieferten Ladungspakets vorbereitet werden.

Man erkennt aus den obigen Darstellungen, daß in allen Fällen auf einen der beiden Identifizierungstöpfe $IT_1$ oder $IT_2$ die Differenz aus den Ladungen im Meßtopf MT und im Invertertopf IT übertragen wird. Dabei ist zwischen dem Fall, daß die übertragene Ladung den betreffenden Identifizierungstopf ganz ausfüllt und in den Summationstopf ST überläuft, und dem Fall, daß die Kapazität des Identifizierungstopfs IT durch die übertragene Ladungsdifferenz nur teilweise ausgenutzt wird, zu unterscheiden.

Hierzu ist nun folgendes festzustellen :

Neben dem Komparator $K_2$ sind die Identifizierungstöpfe $IT_1$ und $IT_2$ mit je einem Komparator $K_3$ bzw. $K_4$ über je eine zur Feststellung des Oberflächenpotentials $\varphi_s$ am Ort des betreffenden Identifizierungstopfes dienenden Sonde (es können die den zweiten Komparator $K_2$ steuernden Sonden $So_3$ und $So_4$ sein) versehen. Die Referenzspannung dieser beiden Komparatoren $K_3$ und $K_4$ wird durch eine Sonde $So_5$ am Ort der Schwelle $S_5$ zwischen dem ersten Identifizierungstopf $IT_1$ und dem Summationstopf ST bzw. durch eine Sonde $So_7$ am Ort der Schwelle $S_6$ zwischen dem zweiten Identifizierungstopf $IT_2$ und dem Summationstopf ST erzeugt. Beide Sonden $So_5$ und $So_7$ dienen wieder zur Feststellung des Oberflächenpotentials $\varphi_s$ am Ort der betreffenden Schwelle.

Diese Referenzsspannungen entsprechen dem höchsten zu digitalisierenden Analogwert, z. B. von 3,14 dBmO mit dem digitalen Entscheidungswert « 4096 » bei der sog. « A-Law-Compandierung ». Wenn bei einem größeren Signal der zuerst ansprechende Identifizierungstopf $IT_1$ bzw. $IT_2$ voll ist, spricht der entsprechende Komparator $K_3$ oder $K_4$ an und die aus dem Meßtopf MT bzw. dem Invertertopf IT geflossene Ladung wird über die Schwelle $S_5$ bzw. $S_6$ in den Summationstopf ST geleitet. Das Ansprechen eines der beiden Komparatoren $K_3$ bzw. $K_4$ zeigt das Vorliegen des ersten der beiden oben angegebenen Fälle, das Nichtansprechen das Vorliegen des zweiten dieser Fälle an. Sie werden im Folgenden als Fall a) und als Fall b) bezeichnet. Der weitere Prozeß für die Ermittlung des dem am Signaleingang der Anlage anhängigen Signals entsprechenden Digitalwertes ist für die Fälle a) und b) gleich. Allerdings ist für den Fall b) noch eine weitere Erörterung erforderlich, die nach der Beschreibung des Summationsvorganges gebracht wird.

Für den weiteren Verlauf der Ermittlung des dem am Signaleingang der Anlage anhängigen Analogsignals entsprechenden Digitalsignals ist es von Bedeutung, daß die Schwellen $S_5$, $S_6$ und die

zwischen der Ladungsquelle $L_2$ und dem zweiten Verdopplertopf VT* liegende Schwelle $S_7$ durch auf einem gemeinsamen Potential gehaltene Gateelektroden gesteuert werden, also ihre Gateelektroden miteinander verbunden sind. Außerdem ist eine Sonde zur Messung des Oberflächenpotentials am Ort einer dieser Schwellen zur Beaufschlagung eines weiteren Komparators $K_5$ vorgesehen, dessen zweiter Eingang mit einer entsprechenden Sonde $So_6$ am Ort des Summationstopfes ST verbunden ist. In dem in Fig. 1 dargestellten Beispielsfall ist die an der Schwelle $S_5$ zur Beaufschlagung des Komparators $K_3$ vorgesehene Sonde $So_5$ an den einen Eingang des zuletzt eingeführten Komparators $K_5$ gelegt.

Bei der Auswertung des jeweiligen Ladungsinhalts des Summationstopfes ST wird zunächst der zweite Verdopplertopf VT* aufgeladen. Hierzu ist durch eine entsprechende Spannung « 4096 » (= $2^{12}$) zwischen dem die Schwelle $S_7$ definierendem Gate und dem Anschluß des den MOS-Kondensator bildenden Gate VT* die Schwelle $S_7$ geöffnet, so daß Ladung aus der zweiten Ladungsquelle $L_2$ in den zweiten Verdopplertopf VT* einfließen kann. Zu bemerken ist dabei, daß die Gates des Summationstopfes ST und des zweiten Verdopplertopfes VT* hierbei, um gleiche Raumladungstiefen zu erhalten, miteinander verbunden werden. In analoger Weise zur Aufladung des ersten Verdopplertopfes VT wird auch im Falle des zweiten Verdopplertopfes VT* die überschüssige Ladung aus dem Verdopplertopf in die Ladungsquelle $L_2$ zurückgegeben, indem bei geöffneter Schwelle $S_7$ der Anschluß der Ladungsquelle $L_2$ auf den Wert des Potentials der Gateelektrode des zweiten Verdopplertopfes VT* gebracht wird. Es verbleibt dann genau eine Ladungsmenge im zweiten Verdopplertopf VT*, die proportional der Spannungsdifferenz am Gate der Schwelle $S_7$ und am Gate des zweiten Verdopplertopfes VT* ist.

Nun wird die Gatespannung des Summationstopfs ST und des zweiten Verdopplertopfs VT* gemeinsam abgesenkt. Dabei fließ Ladung, die aufgrund der kleineren Gatespannung im zweiten Verdopplertopf VT* nicht mehr gehalten werden kann, über die Schwelle $S_7$ in die Ladungsquelle $L_2$ zurück. Das Oberflächenpotential $\varphi_s$ am Ort des Summationstopfs ST nähert sich durch das Absenken der Spannung dem Oberflächenpotential der Schwelle $S_5$. Der über die Sonden $So_5$ und $So_6$ beaufschlagte Komparator $K_5$ spricht bei Gleichheit der Oberflächenspannungen an und stoppt somit den Absenkvorgang.

Damit ist erreicht, daß nicht nur die Oberflächenspannungen am Ort der Schwelle $S_5$ und des Summationstopfes ST einander gleich sind, sondern auch — da die Gates der Schwelle $S_5$ und der Schwelle $S_7$ galvanisch miteinander verbunden sind und diese aus dem gleichen Prozeßschritt stammen — auch die Oberflächenspannungen an der Schwelle $S_7$ und am zweiten Verdopplertopf VT* denselben Wert haben. Ferner sind die den Summationstopf ST und den zweiten Verdopplertopf VT* darstellenden MOS-Kondensatoren ebenfalls in einem gleichen Prozeßschritt hergestellt worden und ihre Gates zusammengeschaltet. Beide MOS-Kondensatoren liegen somit an derselben Spannung, so daß die Mengen der beweglichen Ladungen in ihren gleichgroßen Raumladungszonen ebenfalls gleichgroß sind. Die im zweiten Verdopplertopf VT* befindliche Ladungsmenge wird nun durch Öffnen der Schwelle $S_8$ auf den Summationstopf ST übertragen und damit zu der bereits dort befindlichen Ladung addiert. Dami die Ladungsübergabe komplet erfolgt, wird die Spannung am Gate des Summationstopfs ST wieder auf den Anfangswert gebracht und die Spannung am Gate des Schwelle $S_7$ auf den Wert « Null » abgesenkt.

Anschließend an die Ladungsübertragung aus dem zweiten Verdopplertopf VT* in den Summationstopf ST wird die Schwelle $S_8$ wieder geschlossen und nach Anlegen von Spannung an seinem Gate der zweite Verdopplertopf VT* erneut mit Ladung in der bereits beschriebenen Weise gefüllt.

Nun wird geprüft, welche Ladungsmenge sich im Summationstopf ST befindet. Hierzu stehen verschiedene bekannte Möglichkeiten zur Verfügung. Eine dieser Möglichkeiten ist in der DE-A1-2 704 711 (Titel : « CCD-Speicherbaustein ») beschrieben. Diese Methode verlangt die Ergänzung des bisher beschriebenen Teils der in Fig. 1 dargestellten Anlage durch einen Dekodierer D, der z. B. sechzehn weitere MOS-Kondensatoren aufweist, die durch kettenförmig auf der den Halbleiterbereich der MOS-Kondensatoren bedeckenden Oxydschicht angeordnete und durch je eine Schwelle von einander und von der Ladungsquelle, d. h. im vorliegenden Fall vom Summationstopf ST, getrennt sind. Einzelheiten bezüglich des Dekodierers D sind der DE-A1-2 704 711 entnehmbar, so daß dieser in der Fig. 1 lediglich als Block dargestellt wurde. Die zwischen ihm und dem Summationstopf ST liegende Schwelle ist mit TF bezeichnet. Die aus der DE-A1-2 704 711 entnehmbare Sturktur des Dekodierers D ist immer anwendbar, wenn die zu prüfende bzw. auszuwertende Ladungsmenge größer als die Mindestschwelle « 2048 » (= 4096 : 2) ist.

Dabei sind in diesem Beispiel 16 MOS-Kondensatoren vom Volumen « 128 » bezogen auf « 4096 » im Dekoder D vorgesehen. Das Gate, das den ersten dieser MOS-Kondensatoren definiert, ist gleichzeitig das Transfergate TF für die Ladung aus dem Summationstopf ST, die dann ggf. weitere MOS-Kondensatoren der Größe « 128 » füllt. Durch Absenken der Spannung am Gate des Summationstopfs ST auf die Referenzspannung von « 2048 » werden, wenn sich eine größere Ladungsmenge im Summationstopf ST befindet, als sie dieser Referenzspannung bei der Fläche des Summationstopfs ST entspricht, diese über eine weitere Schwelle in die den Dekodierer D bildenden MOS-Kondensatoren überströmen. Ein Maß, wieviel mehr Ladung sich im Summationstopf ST befindet, als bei einer Referenzspannung von « 2048 » in den 16 MOS-Kondensatoren des Dekodierers D Platz findet, ist durch die Anzahl der jeweils von Ladungen überschwemmten MOS-Kondensatoren « 128 » gegeben. Neben dieser CCD-spezifischen und in der DE-A1-2 704 711 ausführlich beschriebenen Methode ist z. B. die

7

Möglichkeit des Vergleichs mit sechzehn Referenzsspannungen zu nennen, die entsprechend den Stellenwerten des binären Zahlensystems abgestimmt sind.

Eine weitere CD-spezifische Indikation der Ladungsmenge im Summationstopf ST ist nach Erkennen des Überschreitens der « 2048 »-Niveaus die Addition von bis zu 16 Ladungspaketen mit dem Ladungsvolumen « 128 » bezogen auf den Wert « 4096 ». Der Schluß auf die Größe des ursprünglichen Ladungspakets im Summationstopf ST ergibt sich aus der nötigen Anzahl von Ladungspaketen des Volumens « 2128 » bis zur Überschreitung des Schwelle von « 4096 ».

Referenzspannungen können dadurch erzeugt werden, daß ein definiertes Ladungspaket der kleinsten Größe durch das beschriebene Additionsverfahren mit einer bestimmten Anzahl von Schritten auf den Referenzwert gebracht und der sich ergebende Spannungswert dann mittels einer entsprechenden Anzahl von Sample- and-Hold-Gliedern gespeichert wird. Der gespeicherte Wert muß zyklisch erneuert werden.

Nunmehr soll auch der oben erwähnte Fall b) näher beschrieben werden, bei dem die Ladung in der infolge der anliegenden Gatespannung gebildeten Raumladungszone des Identifizierungstopfs $IT_1$ bzw. $IT_2$ Platz findet, ohne die Schwelle mit ihrem Entscheidungswert « 4096 » zu überschreiten. Es soll nochmals darauf hingewiesen werden, daß die Gateflächen der MOS-Kondensatoren $IT_1$ bzw. $IT_2$ nur den sechzehnten Teil der Gatefläche des zweiten Verdopplertopfes VT* bzw. des Summationstopfes ST betragen und daß in den Summationstopf ST im Gegensatz zu dem vorher beschriebenen Fall a) keine Ladung übertragen ist, was man aufgrund des Nichtansprechens des Komparators $K_5$ erkennt.

Auch im Fall b) wird die Ladung in den zweiten Verdopplertopf VT* in der bereits oben beschriebenen Weise eingegeben. Anschließend werden die Gates von $IT_1$ und $IT_2$ mit dem Gate des zweiten Verdopplertopfes VT* verbunden. Für das Bemessen der Ladungsmenge für den zweiten Verdopplertopf VT* muß nun die Oberflächenspannung in dem Identifizierungstopf, der das Ansprechen des Komparators $K_2$ veranlaßt hat, mit der Oberflächenspannung der Schwelle verglichen werden, die sich zwischen diesem Identifizierungstopf und dem Summationstopf ST befindet. Hierzu können die Komparatoren $K_3$ bzw. $K_4$ herangezogen werden. Die Ladungsgleichheit wird dadurch gewährleistet, daß die Schwelle $S_7$ zwischen der zweiten Ladungsquelle $L_2$ und dem zweiten Verdopplertopf VT* und die Schwellen $S_6$ und $S_7$ zwischen dem Summationstopf und den Identifizierungstöpfen aus dem gleichen Fertigungsprozeß stammen und die sie bildenden Gates auf gleicher Spannung liegen.

Zum Vergleichsvorgang wird das Potential am Gate der beiden Identifizierungstöfe $IT_1$ und $IT_2$ sowie am Gate des zweiten Verdopplertopfes VT* in Richtung auf das Potential des Anschlusses des Halbleiterbereichs der MOS-Kondensatoren verschoben, also die Spannung an diesen MOS-Kondensatoren abgesenkt. Dabei fließt die Ladung, die sich infolge der hierdurch bedingten Verkleinerung der Raumladungszone im zweiten Verdopplertopf VT* nicht mehr halten kann, in die zweite Ladungsquelle $L_2$ zurück. Erkennt der Komparator $K_5$ die Gleichheit, dann wird das Absenken der Gatespannungen gestoppt. Nun liegt im zweiten Verdopplertopf VT* eine sechsmal größere Ladungsmenge als in dem betreffenden Identifizierungstopf, die dann in der beschriebenen Weise in den Summationstopf ST umgefüllt wird. Die im Identifizierungstopf vorhandene Ladung wird dann abgesaugt, um den Identifizierungstopf für den Prozeß der Verarbeitung des nächsten Ladungspakets vorzubereiten. Die Verarbeitung der nunmehr im Summationstopf ST befindlichen Ladung erfolgt wie im Fall a) in der oben beschriebenen Weise.

Die bisherigen Ausführungen betrafen die Ausbildung der Halbleiterschaltung gemäß der Erfindung als Analog-Digitalwandler. Nunmehr soll auf den Fall der Ausbildung als Digital-Analogwandler eingegangen werden.

Bei der Umwandlung eines Digitalsignals in ein Analogsignal wird von der kleinsten Einheit eines Ladungspakets ausgegangen. Dieses Ladungspaket wird so oft, wie benötigt, aufaddiert, um anschließend — mit sich selbst weiter aufaddiert — eine dem Analogwert entsprechende Ladung zu ergeben. Dieses Ladungspaket wird dann in einem Ausgangsdiffusionsgebiet in einer dem Drain eines MOS-Transistors vom Anreicherungstyp entsprechenden Weise in ein Spannungssignal verwandelt. Dieses Spannungssignal, das in einen Kondensator gespeichert wird, kann dann nach dem geforderten Vorzeichen entsprechend verschoben werden. Die Ladungsmengen für die kleinen Signale werden direkt in das Ausgangsdiffusionsgebiet injiziert, da sie keine weitere Bearbeitung erfordern.

Im einfachsten Fall kann man das zu verarbeitende Digitalsignal zum Aufbau des Zählstandes eines Digitalzählers verwenden und mit jedem der hierzu erforderlichen Zähltakte ein Ladungspaket gleicher Größe erzeugen, die dann über den Analogwert-Addierer sukzessive gespeichert werden. Die dem Digitalsignal entsprechende gespeicherte Gesamtladung wird schließlich in eine das gewünschte Analogsignal bildene Spannung umgewandelt.

Eine besonders vorteilhafte Möglichkeit wird nun anhand der Fig. 2 beschrieben. Der dort dargestellte Digital-Analogwandler besteht aus einem Eingangsteil und einem Verarbeitungsteil. Der Eingangsteil kann z. B. entsprechend der DE-A1-27 04 718 aufgebaut sein. Der den Analogwert-Addierer AD darstellende Verarbeitungsteil besteht aus einer Ladungsquelle L*, die mittels einer Schwelle $p_1$ von einem als Verdopplertopf arbeitenden MOS-Kondensator V getrennt ist. Zwischen dem Verdopplertopf V und dem als Summationstopf dienenden MOS-Kondensator SU ist eine weitere Schwelle $p_2$ vorgesehen.

Die im Eingangsteil von einer Lagungsquelle L gelieferte Ladung wird über eine Schwelle $p_3$ an eine Anzahl von einander gleich bemessenen MOS-Kondensatoren BG, die sog. Bewertungsgates, übergeben,

8

die so ausgestaltet sind, daß ein Ladungsübertritt zwischen den einzelnen MOS-Kondensatoren BG aufgrund der zwischen ihnen vorgesehenen gemeinsamen Schwelle $p_4$ nicht so ohneweiteres möglich ist. Die MOS-Kondensatoren BG sind in der aus Fig. 2 ersichtlichen Weise in zwei parallelen Reihen angeordnet, wobei sich zwischen den beiden Reihen als auch zwischen je zwei benachbarten MOS-Kondensatoren jeder Reihe sich das die Schwelle $p_4$ definierende Gate erstreckt. Die gemeinsame Schwelle $p_4$ kontrolliert außerdem den Ladungsübergang aus der Gemeinschaft der MOS-Kondensatoren BG in einen mit den Identifizierungstöpfen $IT_1$, $IT_2$ des in Fig. 1 dargestellten Analog-Digitalwandler vergleichbaren Identifizierungstopf C. Dieser Identifizierungstopf C steuert unter Vermittlung einer weiteren sich zwichen ihm und den Summationstopf SU befindlichen Schwelle $p_5$ den Ladungsübergang aus den Bewertungs-MOS-Kondensatoren BG in den Summationstopf SU.

Schließlich ist der Identifizierungstopf C mit einer Sonde $S_3^*$, die Schwelle $p_5$ zwischen dem Identifizierungstopf und dem Summationstopf SU mit einer Sonde $S_2^*$ und der Summationstopf SU mit einer Sonde $S_1^*$ zur Bestimmung des Oberflächenpotentials $\varphi_s$ versehen, die zur Beaufschlagung eines Komparators $K^*$ in der aus Fig. 2 ersichtlichen Weise dienen. Mit Hilfe des Komparators $K^*$ wird in einer durch einen Schalter Sch gesteuerten Weise das Oberflächenpotential $\varphi_s$ an der Schwelle $p_5$ mit dem Oberflächenpotential am Summiertopf SU bzw. am Identifizierungstopf C verglichen.

Zu erwähnen ist noch, daß daß die Fläche des Identifizierungstopfs C den sechzehnten Teil der Fläche des Summierungstopfes SU bzw. des Verdopplertopfes V beträgt.

Nach entsprechender Aufbereitung und Speicherung des Digitalsignalworts werden z. B. die letzten vier Bits an die entsprechenden Bewertungsgates BG des Eingabeteils gegeben. Die sich hierdurch in den betreffenden MOS-Kondensatoren BG bildenden Raumladungszonen werden über die Schwelle $p_3$ von aus der Ladungsquelle L stammenden Ladungen überschwemmt. Nach dem Absenken der an der Ladungsquelle L liegenden Spannung strömen überschüssige Ladungen in diese zurück. Außerdem bleiben in den MOS-Kondensatoren BG, die z. B. mit der logischen « 1 » beaufschlagt wurden, Ladungsmengen zurück, die die Größe « 1 » bzw. « 2 » — bezogen auf die Maximalladung « 4032 » — darstellen. Durch Öffnen der Schwelle $p_4$ wird die Ladung aus den MOS-Kondensatoren BG in den Identifizierungstopf C abgesaugt und im Summationstopf SU addiert. Bei kleinen darzustellenden Spannungen werden diese Ladungen direkt in ein als Drain wirkendes (nicht dargestelltes) Ausgangs-Diffusionsgebiet abgesaugt. Bei größeren Spannungen wird zuerst ein Additionsprozeß wie bei der Analog-Digitalwandlung vorgenommen, der durch die weiteren Bits des anhängigen Digitalsignalworts gesteuert wird. Hierzu dient der Verarbeitungsteil AD, also der Analogwert-Addierer, der durch den Verdopplertopf V, den Summationstopf SU, die Ladungsquelle $L^*$ und die sich zwischen diesen Teilen befindliche Schwellen $p_1$ und $p_2$ gegeben ist.

An dem den Ausgang für das Analogsignal darstellenden (nicht gezeichneten) Diffusionsgebiet erhält man das Ausgangssignal in üblicher Weise als Spannung, die mit Hilfe eines MOS-Feldeffekttransistors abgegriffen werden kann. Das Ausgangssignal dieses Transistors wird auf einen Kondensator gespeichert. Durch Belassen oder Shiften des Inhalts dieses Kondensators wird das Signal noch vom ersten Bit des Digitalsignalworts beeinflußt.

Ersichtlich ist bei der Auswertung der aufgrund der von den Bewertungs-MOS-Kondensatoren BG an den Identifizierungstopf C übertragenen Ladung auch der Fall zu berücksichtigen, bei dem die sich aufgrund der am Gate des Identifizierungstofps anliegenden Spannung bildenden Raumladung einstellende bewegliche Ladung im Identifizierungstopf Platz findet, ohne daß dabei Ladung in den Summationstopf SU gelangt und somit der Komparator $K^*$ nicht anspricht, wenn er an die Sonde $S_1^*$ angeschlossen ist. Dies bedeutet mit anderen Worten, daß die Schwelle $p_5$ mit ihrem Entscheidungswert « 4032 » durch die im MOS-Kondensator aufgrund der durch das Digitalwort gegebenen Beaufschlagung der Bewertungs-MOS-Kondensatoren BG auf den Identifizierungstopf C übertragenen beweglichen Ladung nicht überschritten ist.

Hier empfiehlt es sich, wenn die Ladungseingabe aus dem Eingangsteil in den Identifizierungstopf mindestens einmal wiederholt und somit eine Summation von Ladung im Identifizierungstopf C durchgeführt wird. Im Verdopplertopf V wird Ladung in der bereits beschriebenen Weise eingegeben. Anschließend wird das Gate des Identifizierungstopfes C mit dem Gate des Verdopplertopfes V verbunden. Für das Bemessen der Ladung im Verdopplertopf V muß nun die Oberflächenspannung in Identifizierungstopf C mit der Oberflächenspannung der Schwelle $p_5$ im Komparator $K^*$ verglichen werden. Dann wird in entsprechender Weise wie beim Parallelfall beim Betrieb des Analog-Digitalwandlers gemäß Fig. 1 die Gatespannung am Verdopplertopf V und am Identifizierungstopf C so lange abgesenkt, bis der Komparator C die Ladungsgleichheit der beiden MOS-Kondensatoren C und V anzeigt. Dann liegt im Verdopplertopf V eine sechzehnmal so große Ladungsmenge als im Identifizierungstopf C vor, die dann der weiteren Auswertung in der beschriebenen Weise zugeführt wird. Der Identifizierungstopf wird dann durch Absaugen der Ladung in Aufnahmebereitschaft für ein neues Ladungspaket aus den Bewertungs-MOS-Kondensatoren BG versetzt.

Da die zuletzt beschriebene Arbeisweise des Digital-Analogwandlers identisch ist mit der Arbeisweise des Analog-Digitalwandlers und die Gate-Flächen gleich groß sind, wird bei zur Verfügung stehender Wandlungszeit der Analog-Addierer gemeinsam benützt.

Damit ist auch die Arbeitsweise eines der Erfindung entsprechenden Digital-Analogwandlers beschrieben.

Abschließend ist noch zu bemerken, daß sowohl die Analog-Digitalwandlung als auch die Digital-Analogwandlung mit Clock-Breiten von mehr als 10 Nanosekunden und mit Komparationsschritten von mehr als 500 Nanosekunden durchführbar ist.

**Patentansprüche**

1. Monolithisch integrierte, im Zeittakt betriebene Ladungstransportanordnung (CCD-Anordnung) zur Umwandlung einer ersten Signalart in eine zweite Signalart, wobei die eine Signalart analog, die andere digital auftritt, dadurch gekennzeichnet, daß die Ladungstransportanordnung als Analog-Addierer ausgebildet ist, der durch einen MOS-Kondensator (ST ; SU) gegeben ist, der einerseits über eine Schwelle ($S_8$ ; $P_2$) mit einem durch eine Ladungsquelle ($L_2$ ; L*) beaufschlagten weiteren MOS-Kondensator (VT* ; V) in Verbindung steht und andererseits durch wenigstens einen durch das am Signaleingang der Anordnung anhängige Signal beaufschlagten MOS-Kondensator ($IT_1$, $IT_2$ ; C) über eine Schwelle ($S_5$, $S_6$ ; $P_5$) unter Vermittlung wenigtens eines weiteren MOS-Kondensators (IT, MT ; BG) beaufschlagt ist.

2. Analog/Digital-Wandler mit einer monolithisch integrierten, im Zeittakt betriebenen Ladungstransportanordnung (CCD-Anordnung) nach Anspruch 1, dadurch gekennzeichnet, daß das umzuwandelnde Analogsignal in Form eines seinem Analogwert entsprechenden Ladungspakets in einen ersten MOS-Kondensator (MT) eingegeben wird, daß die im Grundladungsbetrieb arbeitende CCD-Anlage einen durch das im ersten MOS-Kondensator (MT) aufgrund des anhängigen Analogsignals vorliegende Ladungspaket gesteuerten ersten Bestandteil ($L_1$, VT) enthält, der ein zum Ladungspaket im ersten MOS-Kondensator (MT) komplementäres und auf den dem höchstwertigen Bit des Wandlers entsprechenden Wert bezogenes Ladungspaket in einem dem ersten MOS-Kondensator (MT) flächengleichen zweiten MOS-Kondensator (IT) erzeugt, daß dabei der das jeweils größere Ladungspaket aufweisende MOS-Kondensator (MT oder IT) zur Steuerung eines als Analog-Addierer wirkenden zweiten Bestandteils vorgesehen ist und dieser zweite Bestandteil derart aufgebaut und gesteuert ist, daß das dem Analogwert entsprechende Ladungspaket in einen dem ersten MOS-Kondensator (MT) flächengleichen dritten MOS-Kondensator (ST) gelangt und dort solange Ladungspakete jeweils der gleichen Größe, wie sie sich jeweils im dritten MOS-Kondensator (ST) befinden, hinzu addiert werden, bis sich im dritten MOS-Kondensator ein Ladungspaket aufgebaut hat, das bezüglich seiner Größe den halben Digitalwert des höchstwertigen Bits überschreitet, daß dann digital gewichtete Ladungspakete z. B. von der Größe 128/4096 zum Ladungspaket im dritten MOS-Kondensator (ST) hinzugefügt oder abgezogen werden, entweder um den Digitalwert des höchstwertigen Bits zu überschreiten oder um den halben Digitalwert dieses Bits zu unterschreiten und daß schließlich aufgrund der hierzu erforderlichen Additionsschritte bzw. Subtraktionsschritte die digitale Größe des Ladungspakets im ersten MOS-Kondensator (MT) festgestellt und als digitales Ausgangssignal verwendet wird.

3. Analog/Digital-Wandler nach Anspruch 2, dadurch gekennzeichnet, daß der dritte MOS-Kondensator (ST) einerseits über Schwelle ($S_8$) mit einem durch eine Ladungsquelle ($L_2$) beaufschlagten weiteren MOS-Kondensator (VT*) in Verbindung steht und andererseits durch wenigstens einen mit dem ersten MOS-Kondensator (MT) über eine Schwelle ($S_5$) unter Vermittlung eines weiteren MOS-Kondensators ($IT_1$) beaufschlagt ist und daß der das komplementäre Ladungspaket enthaltende zweite MOS-Kondensator (IT) in gleicher Weise wie der erste MOS-Kondensator (MT) unter Vermittlung eines weiteren MOS-Kondensators ($IT_2$) und einer zwischen diesem und dem dritten MOS-Kondensator (ST) liegenden Schwelle ($S_6$) an den dritten MOS-Kondensator (ST) anschaltbar ist.

4. Analog/Digital-Wandler nach den Ansprüchen 2 oder 3, dadurch gekennzeichnet, daß der durch das Analogsignal zu beaufschlagende Signaleingang über ein ein Filter (Tiefpaß) an den als Abtast-Halteglied betriebenen ersten MOS-Kondensator (MT) gelegt ist, daß der der zweite MOS-Kondensator (IT) über eine Schwelle ($S_1$) mit einem ersten der Ladungsverdopplung dienenden MOS-Kondensator (VT) (= Verdopplertopf) und letzterer unter Vermittlung einer weiteren Schwelle ($S_2$) an eine erste Ladungsquelle ($L_1$) gelegt ist, daß ferner der erste MOS-Kondensator (MT) und der erste Ladungsverdopplerkondensator (VT) mit je einer Sonde ($So_1$, $So_2$) zur Bestimmung des Oberflächenpotentials und zur Beaufschlagung eines ersten Komparators ($K_1$) versehen sind, daß außerdem der erste MOS-Kondensator (MT) unter Verwendung einer weiteren Schwelle ($S_3$) an den die Verbindung zum dritten MOS-Kondensator (ST) vermittelnden MOS-Kondensator ($IT_1$) angeschlossen ist, während der zweite MOS-Kondensator (IT) ebenfalls unter Verwendung einer weiteren Schwelle ($S_4$) an den die Vermittlung zum dritten MOS-Kondensator (ST) bewirkenden MOS-Kondensator ($IT_2$) angeschlossen ist, daß ferner die beiden die Verbindung zwischen dem ersten MOS-Kondensator (MT) bzw. dem zweiten MOS-Kondensator (IT) und dem dritten MOS-Kondensator (ST) vermittelnden beiden MOS-Kondensatoren ($IT_1$, $IT_2$) einander flächengleich sind und außerdem unter Vermittlung je einer Sonde ($So_3$, $So_4$) mit einem gemeinsamen Komparator ($K_2$) in Verbindung stehen, daß dabei dieser gemeinsame Komparator ($K_2$) zur Steuerung einer dem höchstwertigen Bit zugeordneten Speicherzelle (SP) dient, daß weiterhin sowohl der die Verbindung vom ersten MOS-Kondensator (MT) zum dritten MOS-Kondensator (ST) bildende MOS-Kondensator ($IT_1$) als auch der die Verbindung vom zweiten MOS-Kondensator (IT) zum dritten MOS-Kondensator (ST) bildende MOS-Kondensator ($IT_2$) über eine Sonde mit je einem weiteren

Komparator ($K_3$ bzw. $K_4$) in Verbindung stehen, dessen zweiter Eingang durch die Schwelle ($S_5$ bzw. $S_6$) zwischen dem dem betreffenden Komparator ($K_3$ bzw. $K_4$) jeweils zugeordneten Vermittlungs-MOS-Kondensator ($IT_1$ bzw. $IT_2$) gesteuert ist.

5. Analog/Digital-Wandler nach Anspruch 4, dadurch gekennzeichnet, daß die die Verbindung vom ersten MOS-Kondensator (MT) bzw. vom zweiten MOS-Kondensator (IT) bildenden Vermittlungs-MOS-Kondensatoren ($IT_1$, $IT_2$) derart bemessen sind, daß sie jeweils nur den sechzehnten Teil der Fläche des ersten MOS-Kondensators (MT) aufweisen.

6. Analog/Digital-Wandler nach einem der Ansprüche 3 bis 5, dadurch gekennzeichnet, daß der den Kern des Analog-Addierers bildende dritte MOS-Kondensator (ST) über eine Sonde ($So_6$) mit einem fünften Komparator ($K_5$) in Verbindung steht, der andererseits — ebenfalls unter Vermittlung einer Sonde ($So_5$) — durch die Schwelle ($S_5$) zwischen dem dritten MOS-Kondensator (ST) und dem Vermitttlungskondensator ($IT_1$) gesteuert ist, der die Verbindung zwischen dem ersten MOS-Kondensator (MT) und dem dritten MOS-Kondensator (ST) bildet.

7. Analog/Digital-Wandler nach einem der Ansprüche 3 bis 6, dadurch gekennzeichnet, daß der dritte MOS-Kondensator (ST) zur Beaufschlagung einer Dekodieranlage (D) unter Vermittlung eines Transfergates (TF) dient.

8. Analog/Digital-Wandler nach einem der Ansprüche 3 bis 7, dadurch gekennzeichnet, daß zur Beaufschlagung des zweiten MOS-Kondensators (IT) mit dem komplementären Ladungspaket der zweite MOS-Kondensator (IT) über eine Schwelle ($S_1$) an einen ihm flächengleichen MOS-Kondensator (VT) anschließbar ist, daß dabei dieser weitere der Aufladung des zweiten MOS-Kondensators (IT) dienende MOS-Kondensator (VT) seinerseits über eine weitere Schwelle ($S_2$) mit einer zweiten Ladungsquelle ($L_1$) in Verbindung steht und außerdem über eine Sonde ($So_2$) der Steuerung eines — zugleich unter Vermittlung einer weiteren Sonde ($So_1$) vom ersten MOS-Kondensator (MT) gesteuerten Komparators ($K_1$) dient.

9. Verfahren zum Betreiben eines Analog/Digital-Wandlers nach Anspruch 8, dadurch gekennzeichnet daß unmittelbar nach dem Eingang eines Ladungspakets in den ersten MOS-Kondensator (MT) das Gate des der Aufladung des zweiten MOS-Kondensators (IT) dienenden MOS-Kondensators (VT) an das Gate des ersten MOS-Kondensators (MT) geschaltet und durch die mit dem Auflade-MOS-Kondensator (VT) in Verbindung stehende Ladungsquelle ($L_1$) eine auf die Summe der doppelten Grundlagung und der sich bei maximaler Signalamplitude am Signaleingang im ersten MOS-Kondensator (MT) einstelnden Ladungsmenge bemessenes Ladungspaket auf den Auflade-MOS-Kondensator (VT) übertragen wird, daß dann unter Öffnen der Schwelle ($S_1$) zwischen dem zweiten MOS-Kondensator (IT) und dem Auflade-MOS-Kondensator (VT) die in letzterem vorhandene Ladung auf den zweiten MOS-Kondensator (IT) unter Absenkung der Spannung an der Gateelektrode des Auflade-MOS-Kondensators (VT) sowie unter Anschaltung der Gateelektrode des zweiten MOS-Kondensators an das ursprüngliche Potential der Gateelektrode des ersten MOS-Kondensators (MT) übertragen wird und außerdem die übertragene Ladungsmenge der Grundladung entspricht, daß nach der Aufnahme der Grundladung in den zweiten MOS-Kondensator (IT) unter Aufrechterhaltung des Potentials am Gate des zweiten MOS-Kondensators (IT) das Potential am Gate des ersten MOS-Kondensators (MT) gemeinsam mit dem Gate des Auflade-MOS-Kondensators (VT) in Richtung auf das Potential des Anschlusses des zusammen mit den Gateelektroden die MOS-Kondensatoren bildenden Halbleiterbereiches solange verschoben wird, bis der sowohl von dem Auflade-MOS-Kondensator (VT) als auch vom ersten MOS-Kondensator (MT) gesteuerte Komparator ($K_1$) anspricht, daß daraufhin das Gate des Auflade-MOS-Kondensators (VT) vom Gate des ersten MOS-Kondensators (MT) gelöst und das Potential des Gates des ersten MOS-Kondensators (MT) auf den ursprünglichen Wert wieder angehoben wird, daß dann das Gate des ersten MOS-Kondensators (MT) mit dem Gate des zweiten MOS-Kondensators (IT) verbunden wird und das Potential der beiden Gates solange in Richtung auf das Potential des Anschlusses des Halbleiterbereichs der MOS-Kondensatoren verschoben wird, bis der zwischen dem ersten MOS-Kondensator (MT) bzw. dem zweiten MOS-Kondensator (IT) einerseits und dem dritten MOS-Kondensator (ST) andererseits vorgesehenen Vermittlungs-MOS-Kondensatoren ($IT_1$, $IT_2$) zugeordnete Komparator ($K_2$) anspricht, und daß daraufhin das erreichte Potential am Gate des ersten MOS-Kondensator (MT) und des zweiten MOS-Kondensators (IT) festgehalten wird, daß mit dem Ansprechen des den beiden Vermittlungskondensatoren ($IT_1$, $IT_2$) zwischen dem ersten MOS-Kondensator (MT) bzw. dem zweiten MOS-Kondensator (IT) und dem dritten MOS-Kondensator (ST) gemeinsam zugeordneten Komparators ($K_2$) der Ladungsempfang eines dieser beiden Vermittlungskondensatoren ($IT_1$, $IT_2$) festgestellt und aufgrund des Ergebnisses dieser Feststellung eine « 1 » oder eine « 0 » in dem durch den Komparator ($K_2$) gesteuerten Speicher (SP) als höchstwertige Bitstelle für das Ausgangssignal festgehalten wird, daß das Potential an den miteinander verbundenen Gates des ersten MOS-Kondensators (MT) und des zweiten MOS-Kondensators (IT) weiter in Richtung auf das Potential des Anschlusses des Halbleiterbereiches der MOS-Kondensatoren verschoben wird, bis aus der Gruppe der beiden Vermittlungs-MOS-Kondensatoren ($IT_1$, $IT_2$) auch der andere Kondensator von ersten bzw. vom zweiten MOS-Kondensator (MT, IT) Ladung aufzunehmen beginnt, und daß unmittelbar mit dem Erreichen dieses Zustands die Potentialverschiebung erneut abrupt angehalten wird daß mit Hilfe weiterer Sonden ($So_5$ bzw. $So_6$) und Komparatoren ($K_3$ bzw. $K_4$) der zuletzt mit der Ladungsaufnahme gestoppte Vermittlungs-MOS-Kondensator ($IT_1$ bzw. $IT_2$) aufgrund seines Flächenverhältnisses zum dritten MOS-Kondensator (ST) zur erstmaligen Steuerung eines Ladungserkennungsprozesses herangezogen wird, wenn die aus dem ersten MOS-Kondensator (MT) bzw. dem zweiten MOS-Kondensator (IT) in einen der Vermittlungskondensatoren (IT₁, IT₂) übertragene Ladung in diesem Platz findet, daß mit dem zweiten Ansprechen des den beiden Vermittlungskondensatoren (IT., IT₂) gemeinsam zugeordneten Komparators (K₂) die Ladungsaufnahme dieser beiden MOS-Kondensatoren (IT., IT_c) beendet ist, daß dann die Gates der beiden Vermittlungs-MOS-Kondensatoren (IT₁, IT₂) miteinander verbunden und ihr Potential gemeinsam in Richtung auf das Potential des die MOS-Kondensatoren mitbildenden Halbleiterbereiches bei geöffneten Schwellen (S₅, S₇) zwischen den beiden Vermittlungs-MOS-Kondensatoren (IT₁, IT₂) und dem dritten MOS-Kondensator (ST) solange verschoben wird, bis die gesamte Ladung aus dem einen bzw. dem anderen Vermittlungs-MOS-Kondensator (IT₁ bzw. IT₂) auf den dritten MOS-Kondensator (ST) übertragen ist, daß die zwischen dem dritten MOS-Kondensator (ST) und den beiden Vermittlungs-MOS-Kondensatoren (IT₁, IT₂) liegenden Schwellen (S₅, S₆) und die zwischen der Ladungsquelle (L₂) im Analog-Addierer und dem die Verbindung dieser Ladungsquelle (L₂) zum dritten MOS-Kondensator (ST) bildenden MOS-Kondensator (VT*) liegende Schwelle (S₇) auf ein gemeinsames Potential ihrer Gateelektroden geschaltet werden, daß außerdem von der Ladungsquelle (L₂) auf den zwischen ihr und dem dritten MOS-Kondensator (ST) vorgesehenen MOS-Kondensator (VT*) eine Ladungsmenge übertragen wird, die proportional der Spannung am Gate dieses MOS-Kondensators (VT*) — vermindert um die Spannung am Gate der Schwelle (S₇) zwischen diesem MOS-Kondensator (VT*) und der Ladungsquelle (L₂) liegenden Schwelle (S₇) — ist, daß dann die Spannung am Gate des MOS-Kondensators (VT*) abgesenkt und hierzu die Schwelle (S₈) zwischen diesem MOS-Kondensator (VT*) und dem dritten MOS-Kondensator (ST) offengehalten wird daß anschließend an die Ladungsübertragung aus dem durch die Ladungsquelle (L₂) beaufschlagten MOS-Kondensator (VT*) in den dritten MOS-Kondensator (ST) die zwischen diesen beiden MOS-Kondensatoren liegende Schwelle (S₆) wieder geschlossen und der erstgenannte MOS-Kondensator (VT*) durch die Ladungsquelle (L₂) erneut mit Ladung gefüllt wird, und daß schließlich die auf den dritten MOS-Kondensator (ST) insgesamt übertragene Ladungsmenge zur Erzeugung des Digitalsignals ausgewertet wird.

10. Digital/Analog-Wandler mit einer monolithisch integrierten, im Zeittakt betriebenen Ladungstransportanordnung (CCD-Anordnung) nach Anspruch 1, dadurch gekennzeichnet, daß das umzuwandelnde Digitalsignal zur Festlegung des Ausgangszählstandes eines binären Rückwärtszählers verwendet ist, daß dabei die zur Überführung des Zählstandes dieses Rückwärtszählers aus dem Ausgangszustand in den Nullzustand erforderlichen Zählimpulse gleichzeitig zur Steuerung eines als Analog-Addierer arbeitenden Schaltungsteils (L*, V, SU) dienen, wobei dieser Schaltungsteil derart ausgebildet ist, daß mit jedem bis Erreichen des Nullzustandes des Rückwärtszählers diesem Zugeführten Zählimpuls ein Ladungspaket auf einen gemeinsamen MOS-Kondensator (SU) gelangt und diese Ladungspakete eine binäre Wichtung derart erfahren, daß bei jeweils zwei aufeinanderfolgenden Ladungspaketen das zweite doppelt so groß wie das erste Ladungspaket bemessen ist, und daß schließlich mit dem Erreichen des Zählstands « Null » im Rückwärtszähler die Zufuhr der Ladungspakete in den MOS-Kondensator (SU) beendet ist und das unmittelbar mit der Beendigung der Zufuhr an gewichteten Ladungspaketen im MOS-Kondensator (SU) vorhandene Ladungspaket das zu erzeugende Analogsignal darstellt.

11. Digital/Analog-Wandler nach Anspruch 10, dadurch gekennzeichnet, daß in einem Eingangsteil eine Anzahl einander gleicher und durch eine gemeinsame Schwelle (p₄) voneinander und durch eine gemeinsame Schwelle (p₃) von einer gemeinsamen Ladungsquelle (L) getrennter MOS-Kondensatoren (BG) vorgesehen ist, daß ferner die erstgenannte Schwelle (p₄) auch für die Steuerung des Ladungsübergangs der MOS-Kondensatoren (BG) an einen die Vermittlung zum Analogwert-Addierer (AD) darstellenden sowie von diesem durch eine weitere Schwelle (p₅) getrennten MOS-Kondensator (C) zuständig ist.

12. Digital/Analog-Wandler nach Anspruch 11, dadurch gekennzeichnet, daß der die genannte Vermittlung bewirkende MOS-Kondensator (C) und die sich zwischen diesem und dem ersten MOS-Kondensator (SU) des Analog-Addierers (AD) einschiebende Schwelle (p₅) sowie dieser erste MOS-Kondensator (SU) des Analogwert-Addierers mit je einer Sonde (S₁*, S₂*, S₃*) zur Messung des Oberflächenpotentials und zur Steuerung eines gemeinsamen Komparators (K*) versehen sind.

13. Digital/Analog-Wandler nach Anspruch 12, dadurch gekennzeichnet, daß der Eingangsteil von dem jeweils ankommenden und zu verarbeitenden Digitalsignal einen Teil zur Beaufschlagung der Gates eines Teils der einander gleichen MOS-Kondensatoren (BG) des Eingangsteils abzweigt, während der Rest des Signals zur Steuerung des Analogwert-Addierers (AD) vorgesehen ist.

14. Digital/Analog-Wandler nach den Ansprüchen 10 bis 13, dadurch gekennzeichnet, daß die MOS-Kondensatoren des Analogwert-Addierers (AD) durch flächengleiche Gatelektroden und der die Vermittlung zwischen dem Eingangsteil (BG) und dem Analogwert-Addierer (AD) bewirkende MOS-Kondensator (C) durch ein um den Faktor « 1/16 » kleineres Gate definiert sind und im Vergleich hierzu die Gates der MOS-Kondensatoren (BG) im Eingangsteil des Wandlers jeweils eine noch kleinere Fläche aufweisen.

## Claims

1. A monolithic integrated CCD arrangement operated in timed cyclic fashion and serving to convert

**0 025 845**

a first signal type into a second signal type, where the first signal type occurs in analogue form and the second signal type occurs in digital form, characterised in that the CCD arrangement is an analogue adder represented by a MOS-capacitor (ST ; SU) connected on the one hand *via* a threshold ($S_8$ ; $P_2$) to a further MOS-capacitor (VT* ; V) acted upon by a charge source ($L_2$ ; L*), and on the other hand is acted upon by at least one MOS-capacitor ($IT_1$, $IT_2$ ; C), which is itself acted upon by the signal occurring at the signal input of the arrangement, *via* a threshold ($S_5$, $S_6$ ; $P_5$) by means of at least one further MOS-capacitor (IT, MT ; BG).

2. An analogue/digital converter with a monolithic integrated CCD arrangement operated in timed cycle fashion as claimed in Claim 1, characterised in that the analogue signal to be converted is input into a first MOS-capacitor (MT) in the form of a charge packet corresponding to its analogue value, that the CCD system, which operates in accordance with the basic charge, contains a first component ($L_1$, VT) controlled by the charge packet present in the first MOS-capacitor (MT) on the basis of the occurring analogue signal, and which first component produces in a second MOS-capacitor (IT) equal in area to the first MOS-capacitor (MT) a charge packet complementary to the charge packet in the first MOS-capacitor (MT) and which relates to the value corresponding to the highest-value bit of the converter, that here the MOS-capacitor (MT or IT) which contains the larger charge packet is provided for the control of a second component which acts as an analogue-adder, and this second component is constructed and controlled in such manner that the charge packet which corresponds to the analogue value is fed to a third MOS-capacitor (ST) equal in area to the first MOS-capacitor (MT), where charge packets, each of the same size as those contained in the third MOS-capacitor (ST), are added until a charge packet has been constructed in the third MOS-capacitor whose value exceeds half the digital value of the highest-value bit, that then digitally weighted charge packets, whose size amounts for example to 128/4096, are added to or subtracted from the charge packet in the third MOS-capacitor (ST), either in order to exceed the digital value of the highest-value bit or in order to fall below half the digital value of this bit, and that finally, on the basis of the addition or subtraction steps necessary for this purpose, the digital value of the charge packet in the first MOS-capacitor (MT) is established and is used as digital output signal.

3. An analogue/digital converter as claimed in Claim 2, characterised in that the third MOS-capacitor is connected on the one hand *via* a threshold ($S_8$) to a further MOS-capacitor (VT*) which is acted upon by a charge source ($L_2$), and on the other hand is acted upon by at least one with the first MOS-capacitor (MT) *via* a threshold ($S_5$) by means of a further MOS-capacitor ($IT_1$), and that the second MOS-capacitor (IT) which contains the complementary charge packet can be connected to the third MOS-capacitor (ST) in the same way as the first MOS-capacitor (MT) *via* a further MOS-capacitor ($IT_2$) and a threshold ($S_6$) located between the latter and the third MOS-capacitor (ST).

4. An analogue/digital converter as claimed in Claims 2 or 3, characterised in that the signal input to be acted upon by the analogue signal is connected *via* a filter (low-pass filter) to the first MOS-capacitor (MT) operated as a sample-and-hold component, that the second MOS-capacitor (IT) is connected *via* a threshold ($S_1$) to a first MOS-capacitor (VT) which serves to double the charge (VT = doubler pot), and the latter is connected to a first charge source ($L_1$) *via* a further threshold ($S_2$), that moreover the first MOS-capacitor (MT) and the first charge doubler capacitor (VT) are each provided with a probe ($So_1$, $So_2$) in order that the surface potential may be determined and in order that a first comparator ($K_1$) may be acted upon, that moreover the first MOS-capacitor (MT) is connected *via* a further thershold ($S_3$) to the MOS-capacitor ($IT_1$) which effects the connection to the third MOS-capacitor (ST), whereas the second MOS-capacitor (IT) is connected, likewise *via* a further threshold ($S_4$), to the MOS-capacitor ($IT_2$) which effects the connection to the third MOS-capacitor (ST), that moreover the two MOS-capacitors ($IT_1$, $IT_2$), which effect the connection between the first MOS-capacitor (MT) and the second MOS-capacitor (IT), are equal in surface to one another and are also each connected *via* a probe ($So_3$, $So_4$) to a common comparator ($K_2$), and that this common comparator ($K_2$) serves to control a storage cell (SP) which is assigned the highest value bit, that moreover both the MOS-capacitor ($IT_1$) which forms the connection from the first MOS-capacitor (MT) to the third MOS-capacitor (ST), and also the MOS-capacitor ($IT_2$) which forms the connection from the second MOS-capacitor (IT) to the third MOS-capacitor (ST) are each connected *via* a probe to a further comparator ($K_3$, $K_4$) whose second input is controlled by the threshold ($S_5$, $S_6$) between the switching-MOS-capacitor ($IT_1$, $IT_2$) which is in each case assigned to the comparator in question ($K_3$, $K_4$).

5. An analogue/digital converter as claimed in Claim 4, characterised in that the switching-MOS-capacitors ($IT_1$, $IT_2$) which form the connection from the first MOS-capacitor (MT) and from the second MOS-capacitor (IT) respectively are contrived to be such that they each represent only one sixteenth of the area of the first MOS-capacitor (MT).

6. An analogue/digital converter as claimed in one of the Claims 3 to 5, characterised in that the third MOS-capacitor (ST), which forms the core of the analogue-adder, is connected *via* a probe ($So_6$) to a fifth comparator ($K_5$) which on the other hand — likewise *via* a probe ($So_5$) — is controlled by the threshold ($S_5$) between the third MOS-capacitor (ST) and the switching capacitor ($IT_1$) which forms the connection between the first MOS-capacitor (MT) and the third MOS-capacitor (ST).

7. An analogue/digital converter as claimed in one of the Claims 3 to 6, characterised in that the third MOS-capacitor (ST) serves to act upon a decoder system (D) *via* a transfer gate (TF).

8. An analogue/digital converter as claimed in one of the Claims 3 to 7, characterised in that in order

13

that the second MOS-capacitor (IT) may be acted upon by the complementary charge packet, the second MOS-capacitor (IT) can be connected *via* a threshold (S₁) to a MOS-capacitor (VT) which is equal to itself in area, and that this third MOS-capacitor (VT) which serves to charge the second MOS-capacitor (IT) is itself connected *via* a further threshold (S₂) to a second charge source (L₁), and *via* a probe (So₂) also serves to control a comparator (K₁) which is simultaneously controlled by the first MOS-capacitor (MT) *via* a further probe (So₁).

9. A process for the operation of an analogue/digital converter as claimed in Claim 8, characterised in that directly following the input of a charge packet into the first MOS-capacitor (MT), the gate of the MOS-capacitor (VT) which serves to charge the second MOS-capacitor (IT) is connected to the gate of the first MOS-capacitor (MT) and by means of the charge source (L₁), which is connected to the charging-MOS-capacitor (VT), a charge packet calculated to correspond to the sum of double the basic charge and the quantity of charge which occurs with the maximum signal amplitude at the signal input in the first MOS-capacitor (MT), is transferred to the charging-MOS-capacitor (VT), that then, with the threshold (S₁) between the second MOS-capacitor (IT) and the charging-MOS-capacitor (VT) open, the charge contained therein is transferred to the second MOS-capacitor (IT), with a reduction in the voltage connected to the gate electrode of the charging-MOS-capacitor (VT), and where the gate electrode of the second MOS-capacitor is connected to the original potential of the gate electrode of the first MOS-capacitor (MT), and where the transferred quantity of charge corresponds to the basic charge, that following the accommodation of the basic charge in the second MOS-capacitor (IT), whilst maintaining the potential at the gate of the second MOS-capacitor (IT), the potential connected to the gate of the first MOS-capacitor (MT) together with the gate of the charging-MOS-capacitor (VT), is displaced in the direction of the potential of the terminal of the semiconductor zone which forms the MOS-capacitors together with the gate electrodes, until the response of the comparator (K₁) which is controlled both by the charging-MOS-capacitor (VT) and by the first MOS-capacitor (MT), that then the gate of the charging-MOS-capacitor (VT) is released from the gate of the first MOS-capacitor (MT) and the potential of the gate of the first MOS-capacitor (MT) is raised again to the original value, that then the gate of the first MOS-capacitor (MT) is connected to the gate of the second MOS-capacitor (IT), and the potential of the two gates is displaced in the direction of the potential of the terminal of the semi-conductor zone of the MOS-capacitor until the response of the comparator (K₂) which is assigned to the switching-MOS-capacitors (IT₁, IT₂) which are arranged between the first MOS-capacitor (MT) and the second MOS-capacitor (IT) on the one hand and the third MOS-capacitor (ST) on the other hand, and that then the potential which has been reached at the gate of the first MOS-capacitor (MT) and the second MOS-capacitor (IT) is held, that on the response of the comparator (K₂) which is commonly assigned to the two switching capacitors (IT₁, IT₂) between the first MOS-capacitor (MT) and second MOS-capacitor (IT) and the third MOS-capacitor (ST), the reception of charge by one of these two switching capacitors (IT₁, IT₂) is established and on the basis of the result of this establishment a « 1 » or « 0 » is held in a store (SP), which is controlled by the comparator (K₂), as the highest-value bit digit for the output signal, that the potential at the gates, which are connected to one another, of the first MOS-capacitor (MT) and the second MOS-capacitor (IT) is further displaced in the direction of the potential of the terminal of the semi-conductor zone of the MOS-capacitors until, within a group of the two switching-MOS-capacitors (IT₁, IT₂), the other capacitor begins to receive charge from the first or second MOS-capacitor (MT, IT), and that immediately this state has been reached the potential shift is again abruptly halted, that with the assistance of further probes (So₅, So₆) and comparators (K₃, K₄), on account of its area relationship to the third MOS-capacitor (ST), the switching-MOS-capacitor (IT₁, IT₂) which has last been stopped with the reception of charge, is used for the first control of a charge recognition process when the charge which has been transferred from the first MOS-capacitor (MT) or the second MOS-capacitor (IT) into one of the switching capacitors (IT₁, IT₂) occupies this position, that on the second response of the comparator (K₂), which is commonly assigned to the two switching capacitors (IT₁, IT₂), the reception of charge by these two MOS-capacitors (IT₁, IT₂) comes to an end, but then the gates of the two switching-MOS-capacitors (IT₁, IT₂) are connected to one another and their potential is commonly displaced in the direction of the potential of the semi-conductor zone which co-forms the MOS-capacitors, when the thresholds (S₅, S₇) are open between the two switching-MOS-capacitors (IT₁, IT₂) and the third MOS-capacitor (ST), until all the charge has been transferred from the one or the other switching-MOS-capacitor (IT₁, IT₂) to the third MOS-capacitor (ST), that the thresholds (S₅, S₆) which are located between the first MOS-capacitor (ST) and the two switching-MOS-capacitors (IT₁, IT₂) and the threshold (S₇), which is located between the charge source (L₂) in the analogue-adder and the MOS-capacitor (VT*) which forms the connection between this charge source (L₂) and the third MOS-capacitor (ST), are connected to a common potential of their gate electrodes, that moreover from the charge source (L₂) to the MOS-capacitor (VT*) which is arranged between it and the third MOS-capacitor (ST) a quantity of charge is transferred which is proportional to the voltage connected to the gate of this MOS-capacitor (VT*) — produced by the voltage connected to the gate of the threshold (S₇) between this MOS-capacitor (VT*) and the charge source (L₂), that then the voltage connected to the gate of the MOS-capacitor (VT*) is reduced and for this purpose the threshold (S₈) is kept open between this MOS-capacitor (VT*) and the third MOS-capacitor (ST), that following the transfer charge from the MOS-capacitor (VT*), which is acted upon by the charge source (L₂), into the third MOS-capacitor (ST), the threshold (S₈) arranged between these two MOS-capacitors is closed again

14

and the first-mentioned MOS-capacitor (VT*) is refilled with charge by the charge source ($L_2$), and that finally the total quantity of charge which has been transferred to the third MOS-capacitor (ST) is analysed for the production of the digital signal.

10. A digital-analogue converter with a monolithic integrated CCD arrangement operated in timed cyclic fashion as claimed in Claim 1, characterised in that the digital signal which is to be converted is used to establish the starting count of a binary backwards counter, that here the counting pulses which are required to convert the count of this backwards counter from the starting state to the zero state serves simultaneously to control a circuit component (L*, V, SU) which operates as an analogue-adder, where this circuit component is designed in such manner that with each counting pulse which is supplied to the backwards counter until the zero state is reached, a charge packet is fed to a common MOS-capacitor (SU) and these charge packets experience a binary weighting in such manner that with every two consecutive charge packets, the second charge packet is contrived to be double the first charge packet, and that finally when the « 0 » state is reached in the backwards counter, the supply of the charge packets into the MOS-capacitor (SU) is terminated and the charge packet which occurs at the end of the supply of weighted charge packets in the MOS-capacitor (SU) represents the analogue signal which is to be produced.

11. A digital/analogue converter as claimed in Claim 10, characterised in that in an input component there is arranged a number of MOS-capacitors (BG) which are identical to one another and are separated from one another by a common threshold ($p_4$) and from a common charge source (L), by a common threshold ($p_3$), that moreover the first-mentioned threshold ($p_4$) is also responsible for the control of the charge transfer from the MOS-capacitors (BG) to a MOS-capacitor (C) which represents the switch-through to the analogue-value-adder (AD) and which is separated from the latter by a further threshold ($p_5$).

12. A digital/analogue converter as claimed in Claim 11, characterised in that the MOS-capacitor (C) which effects the aforementioned switch-through, and the threshold ($p_5$) which is interposed between the latter and the first MOS-capacitor (SU) of the analogue-adder (AD), and likewise this first MOS-capacitor (SU) of the analogue-value-adder are each provided with a probe ($S_1^*$, $S_2^*$, $S_3^*$) which serves to measure the surface potential and to control a common comparator (K*).

13. A digital/analogue converter as claimed in Claim 12, characterised in that the input component of the incoming digital signal which is to be processed branches off a section to act upon the gates of a part of the MOS-capacitors (BG), which are identical to one another, of the input component (SIC), whereas the remainder of the signal serves to control the analogue-value-adder (AD).

14. A digital/analogue converter as claimed in Claims 10 to 13, characterised in that the MOS-capacitors of the analogue-value-adder (AD) are defined by gate electrodes which are equal in area, and the MOS-capacitor (C) which effects the switch-through between the input component (BG) and the analogue-value-adder (AD) is defined by a gate which is a factor of « 1/16 » smaller, and in comparison thereto the gates of the MOS-capacitors (BG) in the input component of the converter each possess a smaller area.

## Revendications

1. Dispositif à transfert de charges (dispositif CCD) à intégration monolithique, commandé par horloge, pour convertir un premier type de signal en un second type de signal, l'un des types de signal étant analogique et l'autre numérique, caractérisé en ce qu'il est réalisé comme un additionneur analogique constitué par un condensateur MOS (ST ; SU) qui communique d'une part à travers un élément à seuil ($S_8$ ; $P_2$) avec un autre condensateur MOS (VT* ; V) alimenté par une source de charges ($L_2$ ; L*) et est alimenté d'autre part, à travers un élément à seuil ($S_5$, $S_6$ ; $P_5$) et par l'intermédiaire d'au moins un autre condensateur MOS (IT, MT ; BG), par au moins un condensateur MOS ($IT_1$, $IT_2$ ; C) recevant lui-même le signal appliqué à l'entrée de signal du dispositif.

2. Convertisseur analogique/numérique comprenant un dispositif à transfert de charges (dispositif CCD) à intégration monolithique, commandé par horloge, selon la revendication 1, caractérisé en ce que le signal analogique à convertir est introduit dans un premier condensateur MOS (MT) sous forme d'un paquet de charges correspondant à sa valeur analogique, que le dispositif CCD, opérant en régime à charge de base, contient un premier constituant ($L_1$, VT), commandé par le paquet de charge présent dans le premier condensateur MOS (MT) par suite du signal analogique appliqué, qui engendre dans un second condensateur MOS (IT), de même aire de surface que le premier condensateur MOS (MT), un paquet de charges complémentaire au paquet de charges dans le premier condensateur MOS (MT) et rapporté à la valeur correspondant au bit de poids fort du convertisseur, que le condensateur MOS (MT ou IT) présentant chaque fois le plus grand paquet de charges est utilisé à cet effet pour commander un second constituant agissant comme additionneur analogique et que ce second constituant est construit et commandé de manière que le paquet de charges correspondant à la valeur analogique parvienne dans un troisième condensateur MOS (ST), de même aire de surface que le premier condensateur MOS (MT), dans lequel sont ajoutés des paquets de charges de même grandeur que celui se trouvant chaque fois dans le troisième condensateur MOS (ST), jusqu'à se soit établi, dans le troisième condensateur MOS, un

**0 025 845**

paquet de charges dont la grandeur dépasse la moitié de la valeur numérique du bit de poids fort, que des paquets de charges pondérés numériquement, par exemple de la grandeur 128/4096 sont ensuite ajoutés au paquet de charges dans le troisième condensateur MOS (ST), ou en sont déduits, soit en vue du dépassement de la valeur numérique du bit de poids fort, soit pour descendre au-dessous de la moitié de la valeur numérique de ce bit, et que, enfin, en raison des opérations d'addition ou de soustraction nécessaires à cet effet, la grandeur numérique du paquet de charges dans le premier condensateur MOS (MT) est déterminée et utilisée comme signal de sortie numérique.

3. Convertisseur analogique/numérique selon la revendication 2, caractérisé en ce que le troisième condensateur MOS (ST) communique d'une part à travers un élément à seuil ($S_8$) avec un autre condensateur MOS (VT*) alimenté par une source de charges ($L_2$) et est alimenté d'autre part par au moins un condensateur MOS relié au premier condensateur MOS (MT), à travers un élément à seuil ($S_5$) et par l'intermédiaire d'un autre condensateur MOS ($IT_1$) et que le second condensateur MOS (IT) contenant le paquet de charges complémentaire peut être connecté, de la même manière que le premier condensateur MOS (MT), au troisième condensateur MOS (ST) par l'intermédiaire d'un autre condensateur MOS ($IT_2$) et d'un élément à seuil ($S_6$) situé entre celui-ci et le troisième condensateur MOS (ST).

4. Convertisseur analogique/numérique selon la revendication 2 ou 3, caractérisé en ce que l'entrée de signal, à laquelle est à appliquer le signal analogique, est connectée à travers un filtre (passe-bas) au premier condensateur MOS (MT) utilisé comme élément d'échantillonnage-maintien, que le deuxième condensateur MOS (IT) est connecté à travers un élément à seuil ($S_1$) à un premier condensateur MOS (VT) servant au doublage de la charge (= pot doubleur) et ce dernier est connecté à travers un autre élément ($S_2$) à une première source de charges ($L_1$), que le premier condensateur MOS (MT) et le premier condensateur doubleur de charges (VT) sont en outre munis chacun d'une sonde ($So_1$, $So_2$) pour la détermination du potentiel de surface et pour l'alimentation d'un premier comparateur ($K_1$), que le premier condensateur MOS (MT), avec utilisation d'un autre élément à seuil ($S_3$) est relié en outre au condensateur MOS ($IT_1$) établissant la liaison avec le troisième condensateur MOS (MT), tandis que le deuxième condensateur MOS (IT) est relié, également avec utilisation d'un autre élément à seuil ($S_4$), au condensateur MOS ($IT_2$) établissant la liaison avec le troisième condensateur MOS (ST), que les deux condensateurs MOS ($IT_1$, $IT_2$) établissant la liaison entre le premier condensateur MOS (MT) respectivement le deuxième condensateur MOS (IT) et le troisième condensateur MOS (ST) possèdent la même aire de surface et communiquent en outre chacun à travers une sonde ($So_3$, $So_4$) avec un comparateur commun ($K_2$), que ce comparateur commun ($K_2$) sert à la commande d'une cellule de mémoire (SP) coordonnée au bit de poids fort, que, de plus, à la fois de condensateur MOS ($IT_1$) établissant la liaison entre le premier condensateur MOS (MT) et le troisième condensateur MOS (ST) et le condensateur MOS ($IT_2$) établissant la liaison entre le deuxième condensateur MOS (IT) et le troisième condensateur MOS (ST) communiquent à travers une sonde avec chaque fois un autre comparateur ($K_3$ respectivement $K_4$), dont la deuxième entrée est commandée par l'élément à seuil ($S_5$ respectivement $S_6$) entre le condensateur MOS d'établissement de liaison ($IT_1$ respectivement $IT_2$) coordonné au comparateur concerné ($K_3$ respectivement $K_4$).

5. Convertisseur analogique-numérique selon la revendication 4, caractérisé en ce que les condensateurs MOS d'établissement de liaison ($IT_1$, $IT_2$), établissant la liaison à partir du premier condensateur MOS (MT) respectivement du deuxième condensateur MOS (IT), sont dimensionnés de manière qu'ils présentent chacun seulement la seizième partie de l'aire de surface du premier condensateur MOS (MT).

6. Convertisseur analogique/numérique selon une des revendications 3 à 5, caractérisé en ce que le troisième condensateur MOS (ST), formant le cœur de l'additionneur analogique, communique à travers une sonde ($So_6$) avec un cinquième comparateur ($K_5$), lequel est commandé par ailleurs — également par l'intermédiaire d'une sonde ($So_5$) — par l'élément à seuil ($S_5$) entre le troisième condensateur MOS (ST) et le condensateur d'établissement de liaison ($IT_1$) qui établit la liaison entre le premier condensateur MOS (MT) et le troisième condensateur MOS (ST).

7. Convertisseur analogique/numérique selon une des revendications 3 à 6, caractérisé en ce que le troisième condensateur MOS (ST) sert à agir, avec interposition d'une porte de transfert (TF), sur un dispositif de décodage (D).

8. Convertisseur analogique/numérique selon une des revendications 3 à 7, caractérisé en ce que, pour alimenter le deuxième condensateur MOS (IT) avec le paquet de charges complémentaire, le deuxième condensateur MOS (IT) peut être connecté à travers un élément à seuil ($S_1$) à un condensateur MOS (VT) qui possède la même aire de surface que lui, que ce condensateur MOS supplémentaire (VT), servant à la charge du deuxième condensateur MOS (IT), communique lui-même à travers un autre élément à seuil ($S_2$) avec une deuxième source de charges ($L_1$) et sert en outre, à travers une sonde ($So_2$) à la commande du comparateur ($K_1$) qui est en même temps commandé avec interposition d'une autre sonde ($So_1$) par le premier condensateur MOS (MT).

9. Procédé pour faire fonctionner un condensateur analogique/numérique selon la revendication 8, caractérisé en ce que, immédiatement après l'entrée d'un paquet de charges dans le premier condensateur MOS (MT), la grille du condensateur MOS (VT) servant à la charge du deuxième condensateur MOS (IT) est connectée à la grille du premier condensateur MOS (MT) et la source de charges ($L_1$) communiquant avec le condensateur MOS (VT) de charge transfère au condensateur MOS (VT) de charge un paquet de charges dimensionné selon la somme de la double charge de base et de la

16

quantité de charges qui s'établit dans le premier condensateur MOS (MT) lorsque l'amplitude du signal à l'entrée de signal est maximale, qu'ensuite, avec ouverture de l'élément à seuil (S$_1$) entre le deuxième condensateur MOS (IT) et le condensateur MOS de charge (VT), la charge présente dans ce dernier est transférée au deuxième condensateur MOS (IT), avec abaissement de la tension sur l'électrode de grille du condensateur MOS de charge (VT) ainsi qu'avec connexion de l'électrode de grille du deuxième condensateur MOS au potentiel initial de l'électrode de grille du premier condensateur MOS (MT), la quantité de charges transférée correspondant en outre à la charge de base, qu'à la suite de la réception de la charge de base dans le deuxième condensateur MOS (IT), avec maintien du potentiel sur la grille du deuxième condensateur MOS (IT), le potentiel sur la grille du premier condensateur MOS (MT), ensemble avec le potentiel sur la grille du condensateur MOS de charge (VT), sont décalés vers le potentiel de la borne de la région à semi-conducteur formant avec les électrodes de grille les condensateurs MOS, jusqu'à ce que réagisse le comparateur (K$_1$) sur lequel agissent à la fois le condensateur MOS de charge (VT) et le premier condensateur MOS (MT), qu'ensuite, la grille du condensateur MOS de charge (VT) est déconnectée de la grille du premier condensateur MOS (MT) et le potentiel de la grille du premier condensateur MOS (MT) est relevé à la valeur initiale, que la grille du premier condensateur MOS (MT) est ensuite reliée à la grille du deuxième condensateur MOS (IT) et le potentiel de ces deux grilles est décalé en direction du potentiel de la borne de la région à semi-conducteur des condensateurs MOS, jusqu'à ce que réagisse le comparateur (K$_2$) coordonné aux condensateurs MOS d'établissement de liaison (IT$_1$, IT$_2$) prévus entre le premier condensateur MOS (MT) respectivement le deuxième condensateur MOS (IT) d'une part et le troisième condensateur MOS (ST) d'autre part, et que, ensuite, le potentiel obtenu à la grille du premier condensateur MOS (MT) et du deuxième condensateur MOS (IT) est maintenu, qu'à la réponse du comparateur (K$_2$) coordonné en commun aux deux condensateurs d'établissement de liaison (IT$_1$, IT$_2$) entre le premier condensateur MOS (MT) respectivement le deuxième condensateur MOS (IT) et le troisième condensateur MOS (ST), la réception de charges d'un de ces deux condensateurs d'établissement de liaison (IT$_1$, IT$_2$) est détectée et, sur la base du résultat de cette détection, un « 1 » ou un « 0 » est stocké en tant que position de bit de poids fort pour le signal de sortie dans la mémoire (SP) commandée par le comparateur (K$_2$), que le potentiel des grilles reliées l'une à l'autre du premier condensateur MOS (MT) et du deuxième condensateur MOS (IT) est décalé davantage en direction du potentiel de la borne de la région à semi-conducteur des condensateurs MOS, jusqu'à ce que, dans le groupe des deux condensateurs MOS d'établissement de liaison (IT$_1$, IT$_2$), l'autre condensateur commence également à recevoir une charge du premier ou du deuxième condensateur MOS (MT, IT) et que, dès que cet état est atteint, le décalage de potentiel est de nouveau arrêté de façon abrupte, qu'à l'aide d'autres sondes (So$_5$ respectivement So$_6$) et de comparateurs (K$_3$ respectivement K$_4$), le condensateur MOS d'établissement de liaison (IT$_1$ respectivement IT$_2$) dont la réception de charges a été arrêtée en dernier, est utilisé, en raison de son rapport d'aire de surface avec le troisième condensateur MOS (ST), pour la première commande d'un processus de reconnaissance de charges lorsque la charge transmise depuis le premier condensateur MOS (MT) respectivement le deuxième condensateur MOS (IT) dans l'un des condensateurs d'établissement de liaison (IT$_1$, IT$_2$) trouve la place dans celui-ci, qu'à la deuxième réponse du comparateur (K$_2$) coordonnée en commun aux deux condensateurs d'établissement de liaison (IT$_1$, IT$_2$), la réception de charges de ces deux condensateurs MOS (IT$_1$, IT$_2$) est terminée, que les grilles des deux condensateurs MOS d'établissement de liaison (IT$_1$, IT$_2$) sont ensuite reliées l'une à l'autre et leur potentiel commun est décalé en direction du potentiel de la région à semi-conducteur co-formatrice des condensateurs MOS, les éléments à seuil (S$_5$, S$_7$) entre les deux condensateurs MOS d'établissement de liaison (IT$_1$, IT$_2$) et le troisième condensateur MOS (ST) étant ouverts, jusqu'à ce que toute la charge ait été transférée de l'un ou l'autre condensateur MOS d'établissement de liaison (IT$_1$, respectivement IT$_2$) au troisième condensateur MOS (ST), que les éléments à seuil (S$_5$, S$_6$) situés entre le troisième condensateur MOS (ST) et les deux condensateurs MOS d'établissement de liaison (IT$_1$, IT$_2$) et l'élément à seuil (S$_7$) situé entre la source de charges (L$_2$) dans l'additionneur analogique et le condensateur MOS (VT*) établissant la liaison de cette source de charges (L$_2$) avec le troisième condensateur MOS (ST), sont reliés à un potentiel commun par leurs électrodes de grille, que, en plus, la source de charges (L$_2$) transfère, au condensateur MOS (VT*) prévu entre elle et le troisième condensateur MOS (ST), une quantité de charges qui est proportionnelle à la tension sur la grille de ce condensateur MOS (VT*), diminuée de la tension sur la grille de l'élément à seuil (S$_7$) entre le condensateur MOS (VT*) et la source de charges (L$_2$), que la tension sur la grille du condensateur MOS (VT*) est ensuite abaissée et que l'élément à seuil (S$_8$) entre ce condensateur MOS (VT*) et le troisième condensateur MOS (ST) est à cet effet maintenu ouvert, qu'à la suite du transfert de charges depuis le condensateur MOS (VT*) alimenté par la source de charges (L$_2$) dans le troisième condensateur MOS (ST), l'élément à seuil (S$_8$) situé entre ces deux condensateurs MOS est refermé et le condensateur MOS (VT*) mentionné en premier est de nouveau rempli de charges par la source de charges (L$_2$) et que, enfin, la quantité de charges totale transférée au troisième condensateur MOS (ST) est exploitée pour la production du signal numérique.

10. Convertisseur numérique-analogique comportant un dispositif à transfert de charges (dispositif CCD) à l'intégration monolithique, commandé par horloge, selon la revendication 1, caractérisé en ce que le signal numérique à convertir est utilisé pour fixer la position de départ d'un compteur à rebours binaire, que les impulsions de comptage nécessaires pour faire passer la position de ce compteur à rebours de

17

l'état de départ à l'état zéro sont utilisées en même temps pour commander une partie de circuit (L*, V, SU) opérant comme additionneur analogique, cette partie de circuit étant réalisée de manière qu'avec chaque impulsion de comptage appliquée à ce compteur à rebours, jusqu'à ce que celui-ci atteigne la position zéro, un paquet de charges arrive sur un condensateur MOS (SU) commun et que ce paquet de charges soit soumis à une pondération binaire de manière que pour chaque fois deux paquets de charges qui se suivent, le deuxième soit deux fois plus grand que le premier paquet de charges et que, enfin, lorsque le compteur à rebours atteint la position « zéro », l'amenée des paquets de charges dans le condensateur MOS (SU) est terminée et le paquet de charges présent à la fin de l'amenée des paquets de charges pondérés dans le condensateur MOS (SU) représente le signal analogique à produire.

11. Convertisseur numérique-analogique selon la revendication 10, caractérisé en ce qu'il comprend, dans une partie d'entrée, un certain nombre de condensateurs MOS (BG) identiques entre eux et séparés entre eux par un élément à seuil ($p_4$) et d'une source de charges commune (L) par un élément à seuil commun ($p_3$), que l'élément à seuil ($p_4$) mentionné en premier sert en outre à la commande du transfert de charges des condensateurs MOS (BG) à un condensateur MOS (C) qui représente la liaison avec l'additionneur de valeur analogique (AD) et qui est séparé de celui-ci par un autre élément à seuil ($p_5$).

12. Convertisseur numérique/analogique selon la revendication 11, caractérisé en ce que le condensateur MOS (C) mentionné d'établissement de liaison et l'élément à seuil ($p_5$) intercalé entre ce condensateur et le premier condensateur MOS (SU) de l'additionneur analogique (AD), de même que le premier condensateur MOS (SU) de l'additionneur de valeur analogique, sont munis chacun d'une sonde ($S_1^*$, $S_2^*$, $S_3^*$) pour la mesure de potentiel de surface et pour la commande d'un comparateur commun ($K^*$).

13. Convertisseur numérique/analogique selon la revendication 12, caractérisé en ce que la partie d'entrée dévie, du signal numérique arrivant et à traiter, une partie destinée à agir sur les grilles d'une partie des condensateurs MOS (BG) identiques entre eux de la partie d'entrée, tandis que le reste du signal est prévu pour commander l'additionneur de valeur analogique (AD).

14. Convertisseur numérique/analogique selon les revendications 10 à 13, caractérisé en ce que les condensateurs MOS de l'additionneur de valeur analogique (AD) sont définis par des électrodes de grille de même aire et le condensateur MOS (C) établissant la liaison entre la partie d'entrée (BG) et l'additionneur de valeur analogique (AD) est défini par une grille plus petite du facteur « 1/16 » et que, en comparaison avec cela, les grilles des condensateurs MOS (BG) dans la partie d'entrée du convertisseur présentant chacune une aire de surface encore plus petite.

0 025 845

# FIG 1

1

FIG 2